# EUROPEAN PATENT APPLICATION

(11) **EP 4 436 335 A1**
(43) Date of publication of application: **25.09.2024**
(21) Application number: 24159205.4
(22) Date of filing: 22.02.2024
(51) Int. Cl.: H10K 50/19, H10K 59/12, H10K 71/20

(54) **DISPLAY DEVICE, METHOD OF MANUFACTURING DISPLAY DEVICE, AND ELECTRONIC DEVICE**

(30) Priority: 24.03.2023 KR 20230039206; 16.06.2023 KR 20230077715
(71) Applicant: Samsung Display Co., Ltd., Yongin-si, Gyeonggi-do 17113 (KR)
(72) Inventor: MOON, Youngmin, 17113 Yongin-si (KR); KIM, Arong, 17113 Yongin-si (KR); PARK, Heemin, 17113 Yongin-si (KR)
(74) Representative: Marks & Clerk LLP

(57) **Abstract**

A display device includes a first pixel electrode and a second pixel electrode that are spaced from each other on a substrate, a pixel-defining layer including a first opening and a second opening, a first lower emission layer on the first pixel electrode, a second lower emission layer on the second pixel electrode, a first charge generation layer interposed between the first lower emission layer and a first upper emission layer, a second charge generation layer interposed between the second lower emission layer and a second upper emission layer, an opposite electrode on the first pixel electrode and the second pixel electrode, a heating metal layer on the pixel-defining layer and arranged between the first opening and second opening when seen from a direction perpendicular to the substrate, and an inorganic insulating layer covering the heating metal layer.

## Description

### BACKGROUND

### 1. Field

One or more embodiments relate to a display device, a method of manufacturing the display device, and an electronic device.

### 2. Description of the Related Art

To provide various functions, electronic devices may include display devices that provide visual information such as images and videos to a user. Some layers included in the display devices may be provided commonly to a plurality of display elements. Accordingly, when a current is provided to one display element, the current may also be provided to other neighboring display elements through the layers provided commonly to the plurality of display elements, which may lead to degradation of color purity.

### SUMMARY

According to display devices in related arts, a layer provided commonly to a plurality of display elements and patterned should not be in contact with a heating metal layer for generating joule heat. To this end, a part of the layer provided commonly to the plurality of display elements should be removed more than a width of the heating metal layer. Accordingly, a voltage applied to the heating metal layer as well as the temperature of the heating metal layer increase. As a result, in the display devices of related arts, components adjacent to the heating metal layer may be damaged during the process of removing the part of the layer provided commonly to the plurality of display elements through the joule heat. To overcome such an issue, by removing a part of a layer provided commonly to a plurality of display elements by using joule heat, the layer provided commonly to the plurality of display elements may be patterned.

To overcome such issues, one or more embodiments include a display device, in which a current leakage is reduced and a possibility of occurrence of defects during a manufacturing process is reduced, a method of manufacturing the display device, and an electronic device. However, such technical aspect is provided merely as an example, and thus does not pose a limitation on the scope of the present disclosure. In one or more embodiments, a display device in which a current leakage is reduced and a possibility of occurrence of defects during a manufacturing process is reduced, a method of manufacturing the display device, and an electronic device is provided.

Additional aspects will be set forth in part in the description which follows and, in part, will be apparent from the description, or may be learned by practice of the presented embodiments of the present disclosure.

According to one or more embodiments, a display device includes a first pixel electrode and a second pixel electrode that are spaced from each other on a substrate, a pixel-defining layer including a first opening exposing a central portion of the first pixel electrode and a second opening exposing a central portion of the second pixel electrode, a first lower emission layer arranged on the first pixel electrode, a second lower emission layer arranged on the second pixel electrode, a first upper emission layer arranged on the first lower emission layer, a second upper emission layer on the second lower emission layer, a first charge generation layer interposed between the first lower emission layer and the first upper emission layer, a second charge generation layer interposed between the second lower emission layer and the second upper emission layer, an opposite electrode on the first pixel electrode and the second pixel electrode, a heating metal layer on the pixel-defining layer and arranged between the first opening and the second opening when seen from a direction perpendicular to the substrate, and an inorganic insulating layer covering the heating metal layer.

The first charge generation layer and the second charge generation layer may be spaced from each other, a part of the first charge generation layer may overlap a part of the heating metal layer, and a part of the second charge generation layer may overlap another part of the heating metal layer.

A part of the inorganic insulating layer may be interposed between a part of the first charge generation layer and a part of the heating metal layer, and another part of the inorganic insulating layer may be interposed between a part of the second charge generation layer and another part of the heating metal layer.

The inorganic insulating layer may cover an upper surface and a lateral surface of the heating metal layer.

The inorganic insulating layer may cover an upper surface of the pixel-defining layer.

The heating metal layer may surround each of the first opening and the second opening on a plane.

The display device may further include a 1-1 common layer interposed between the first pixel electrode and the first lower emission layer, a 1-2 common layer interposed between the second pixel electrode and the second lower emission layer, a 2-1 common layer interposed between the first lower emission layer and the first charge generation layer, and a 2-2 common layer interposed between the second lower emission layer and the second charge generation layer, wherein the 1-1 common layer and the 1-2 common layer may be spaced from each other, the 2-1 common layer and the 2-2 common layer may be spaced from each other, a part of the 1-1 common layer and a part of the 2-1 common layer may overlap a part of the heating metal layer, and a part of the 1-2 common layer and a part of the 2-2 common layer may overlap another part of the heating metal layer.

A part of the inorganic insulating layer may be interposed between a part of the 1-1 common layer and a part of the heating metal layer, and another part of the inorganic insulating layer may be interposed between a part of the 1-2 common layer and another part of the heating metal layer.

The display device may further include a 3-1 common layer interposed between the first charge generation layer and the first upper emission layer, a 3-2 common layer interposed between the second charge generation layer and the second upper emission layer, a 4-1 common layer interposed between the first upper emission layer and the opposite electrode, and a 4-2 common layer interposed between the second upper emission layer and the opposite electrode.

The 3-1 common layer and the 3-2 common layer may be spaced from each other, and the 4-1 common layer and the 4-2 common layer may be spaced from each other.

The 3-1 common layer may be in contact with the 3-2 common layer, and the 4-1 common layer may be in contact with the 4-2 common layer.

According to one or more embodiments, a method of manufacturing a display device includes forming a first pixel electrode and a second pixel electrode that are spaced from each other on a substrate, forming, on the substrate, a pixel-defining layer including a first opening exposing a central portion of the first pixel electrode and a second opening exposing a central portion of the second pixel electrode, forming, on the pixel-defining layer, a heating metal layer between the first opening and the second opening when seen from a direction perpendicular to the substrate, forming, on the pixel-defining layer, an inorganic insulating layer covering the heating metal layer, forming a first preliminary common layer over the first pixel electrode and the second pixel electrode, forming, on the first preliminary common layer, a first lower emission layer and a second lower emission layer overlapping the first pixel electrode and the second pixel electrode, respectively, forming a second preliminary common layer over the first lower emission layer and the second lower emission layer, forming a preliminary charge generation layer on the second preliminary common layer, forming a third preliminary common layer on the preliminary charge generation layer, forming, on the third preliminary common layer, a first upper emission layer and a second upper emission layer overlapping the first lower emission layer and the second lower emission layer, respectively, forming a fourth preliminary common layer over the first upper emission layer and the second upper emission layer, removing a part of the first preliminary common layer, a part of the second preliminary common layer, a part of the preliminary charge generation layer, a part of the third preliminary common layer, and a part of the fourth preliminary common layer, each overlapping the heating metal layer, by applying a voltage to the heating metal layer, and forming an opposite electrode over the first pixel electrode and the second pixel electrode.

The forming of the inorganic insulating layer may include forming the inorganic insulating layer to cover an upper surface and a lateral surface of the heating metal layer.

The forming of the heating metal layer may include forming the heating metal layer to be around each of the first opening and the second opening on a plane.

The removing of the part of the first preliminary common layer, the part of the second preliminary common layer, the part of the preliminary charge generation layer, the part of the third preliminary common layer, and the part of the fourth preliminary common layer may include removing a part of the first preliminary common layer, a part of the second preliminary common layer, a part of the preliminary charge generation layer, a part of the third preliminary common layer, and a part of the fourth preliminary common layer, each overlapping a central portion of the heating metal layer.

According to one or more embodiments, a method of manufacturing a display device includes forming a first pixel electrode and a second pixel electrode that are spaced from each other on a substrate, forming, on the substrate, a pixel-defining layer including a first opening exposing a central portion of the first pixel electrode and a second opening exposing a central portion of the second pixel electrode, forming, on the pixel-defining layer, a heating metal layer arranged between the first opening and the second opening when seen from a direction perpendicular to the substrate, forming, on the pixel-defining layer, an inorganic insulating layer covering the heating metal layer, forming a first preliminary common layer over the first pixel electrode and the second pixel electrode, forming, on the first preliminary common layer, a first lower emission layer and a second lower emission layer overlapping the first pixel electrode and the second pixel electrode, respectively, forming a second preliminary common layer over the first lower emission layer and the second lower emission layer, forming a preliminary charge generation layer on the second preliminary common layer, removing a part of the first preliminary common layer, a part of the second preliminary common layer, and a part of the preliminary charge generation layer, each overlapping the heating metal layer, by applying a voltage to the heating metal layer, forming a third common layer over a first charge generation layer and a second charge generation layer each formed by removing a part of the preliminary charge generation layer, forming, on the third common layer, a first upper emission layer and a second upper emission layer overlapping the first lower emission layer and the second lower emission layer, respectively, forming a fourth common layer over the first upper emission layer and the second upper emission layer, and forming an opposite electrode over the first pixel electrode and the second pixel electrode.

The forming of the inorganic insulating layer may include forming the inorganic insulating layer to cover an upper surface and a lateral surface of the heating metal layer.

The forming of the heating metal layer may include forming the heating metal layer to be around each of the first opening and the second opening on a plane.

The removing of the part of the first preliminary common layer, the part of the second preliminary common layer, and the part of the preliminary charge generation layer may include removing a part of the first preliminary common layer, a part of the second preliminary common layer, and a part of the preliminary charge generation layer, each overlapping a central portion of the heating metal layer.

According to one or more embodiments, an electronic device includes a display device and a housing accommodating the display device and forming an exterior, wherein the display device includes a first pixel electrode and a second pixel electrode that are spaced from each other on a substrate, a pixel-defining layer including a first opening exposing a central portion of the first pixel electrode and a second opening exposing a central portion of the second pixel electrode, a first lower emission layer on the first pixel electrode, a second lower emission layer on the second pixel electrode, a first upper emission layer on the first lower emission layer, a second upper emission layer on the second lower emission layer, a first charge generation layer interposed between the first lower emission layer and the first upper emission layer, a second charge generation layer interposed between the second lower emission layer and the second upper emission layer, a heating metal layer on the pixel-defining layer and arranged between the first opening and the second opening when seen from a direction perpendicular to the substrate, and an inorganic insulating layer covering the heating metal layer.

Other aspects, features, and advantages which are different than those described above will become apparent from the below detailed description, claims and drawings.

At least some of the above and other features of the invention are set out in the claims.

### BRIEF DESCRIPTION OF THE DRAWINGS

The above and other aspects and features of embodiments of the present disclosure will be more apparent from the following description taken in conjunction with the accompanying drawings, in which:
FIG. 1A is a perspective view schematically illustrating an electronic device according to one or more embodiments;
FIG. 1B is a plan view schematically illustrating a display device according to one or more embodiments;
FIG. 2 is an equivalent circuit diagram of a pixel circuit included in a display device, according to one or more embodiments;
FIG. 3 is an enlarged plan view schematically illustrating a part of the display device of FIG. 1B;
FIG. 4 is a cross-sectional view schematically illustrating the display device of FIG. 3 taken along the line I-I' of FIG. 3;
FIG. 5 is a cross-sectional view schematically illustrating a display device according to one or more embodiments;
FIG. 6 is a cross-sectional view schematically illustrating a display device according to one or more embodiments;
FIGS. 7 to 13 are cross-sectional views for describing a method of manufacturing a display device, according to one or more embodiments;
FIGS. 14 to 17 are cross-sectional views for describing a method of manufacturing a display device, according to one or more embodiments; and
FIG. 18 is a cross-sectional view schematically illustrating a display device according to one or more embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, embodiments of the present disclosure are merely described below, by referring to the figures, to explain aspects of the present disclosure. As used herein, the term "and/or" includes any and all combinations of one or more of the associated listed items. Throughout the present disclosure, the expression "at least one of a, b, or c" indicates only a, only b, only c, both a and b, both a and c, both b and c, all of a, b, and c, or variations thereof.

As embodiments allow for various changes and numerous embodiments, example embodiments will be illustrated in the drawings and described in detail in the written description. The effects, aspects, and features of the present disclosure and methods for achieving the same may be clarified by referring to the following detailed embodiments along with the drawings. The present disclosure may, however, be embodied in many different forms and should not be construed as limited to the example embodiments set forth herein.

Although the terms "first," "second," etc. may be used to describe various elements, these elements should not be limited by these terms. These terms are only used to distinguish one element from another.

An expression used in the singular encompasses the expression of the plural, unless it has a clearly different meaning in the context.

In one or more embodiments below, it will be further understood that the terms "comprises" and/or "comprising" used herein specify the presence of stated features or components, but do not preclude the presence or addition of one or more other features or components.

In the present disclosure, "A and/or B" may include "A," "B," or "A and B." In addition, in the present disclosure, "at least one of A and B" may include "A," "B," or "A and B."

It will be understood that when a component, such as a layer, a film, a region, or a plate, is referred to as being "on" another component, the component can be directly on the other component or intervening components may be present thereon.

It will be understood that when a layer, region, or component is referred to as being connected to another layer, region, or component, it may be directly or indirectly connected to the other layer, region, or component. That is, for example, intervening layers, regions, or components may be present. For example, it will be understood that when a layer, region, or component is referred to as being "electrically connected to" another layer, region, or component, it may be "directly electrically connected to" the other layer, region, or component or may be "indirectly electrically connected to" the other layer, region, or component with one or more intervening layers, regions, or components therebetween.

In the following embodiments, the x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

When a certain embodiment may be implemented differently, a specific process order may be performed differently from the described order. For example, two consecutively described processes may be performed substantially at the same time or performed in an order opposite to the described order.

Hereinafter, embodiments of the present disclosure are described in detail with reference to the attached drawings. Like or corresponding reference numerals in the drawings denote like elements, and any redundant descriptions thereon will be omitted. Sizes of components in the drawings may be exaggerated or reduced for convenience of explanation. In other words, because sizes and thicknesses of components in the drawings are arbitrarily illustrated for convenience of explanation, the present disclosure is not limited thereto.

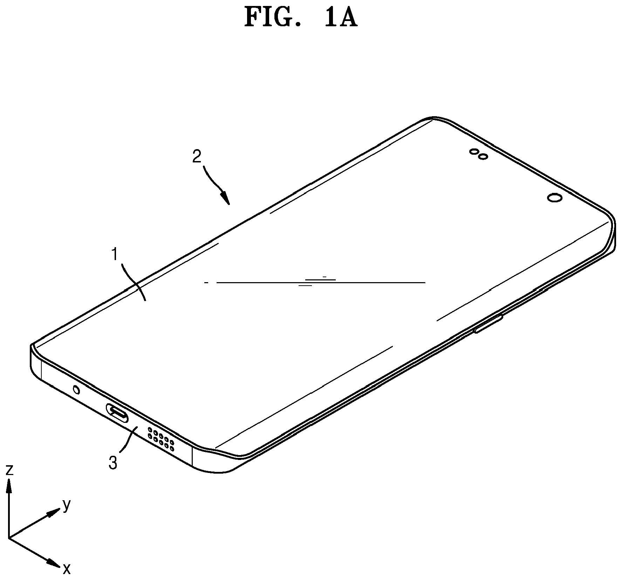

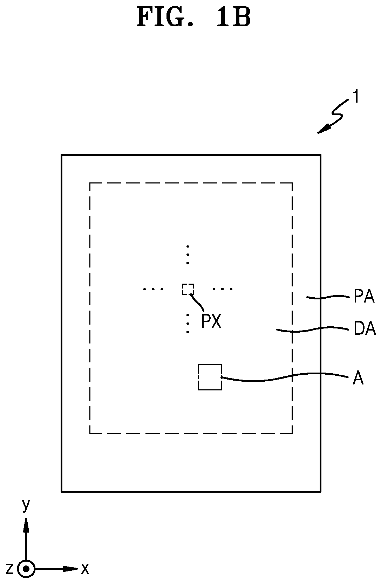

FIG. 1A is a perspective view schematically illustrating an electronic device 2 according to one or more embodiments. FIG. 1B is a plan view schematically illustrating a display device 1 according to one or more embodiments.

As illustrated in FIGS. 1A and 1B, the display device 1 may be a device displaying a video or a static image, and may display a screen image in the electronic device 2 or perform input and output of data.

FIG. 1A illustrates an example in which the display device 1 is used in a mobile phone; however, the present disclosure is not limited thereto. For example, the display device 1 may be used in a portable electronic device such as a mobile phone, a smartphone, a table personal computer (PC), a mobile communication terminal, an electronic notebook, an electronic book, a portable multimedia player (PMP) a navigation device, an ultra-mobile PC (UMPC), etc., or used as a display screen of various electronic devices such as a television, a laptop, a monitor, a signboard, an internet of things (IOT) device, etc.

Also, in one or more embodiments, the display device 1 may be used in a wearable device such as a smartwatch, a watch phone, a glasses-type display, or a head-mounted display (HMD). In one or more embodiments, the display device 1 may be used as a display of various electronic devices, for example, as instrument panels for automobiles, center fasciae for automobiles, or center information displays (CID) arranged on a dashboard, room mirror displays that replace side mirrors of automobiles, and displays arranged on the backside of front seats as an entertainment for back seats of automobiles.

In one or more embodiments, the display device 1 may be accommodated in a housing 3 of the electronic device 2. The housing 3 may be a cover protecting inside components such as the display device 1 and forming the exterior of the electronic device 2. In addition, the display device 1 may be connected to an electronic module of the electronic device 2 and driven on the electronic device 2. Hereinafter, the display device 1 is further described in detail.

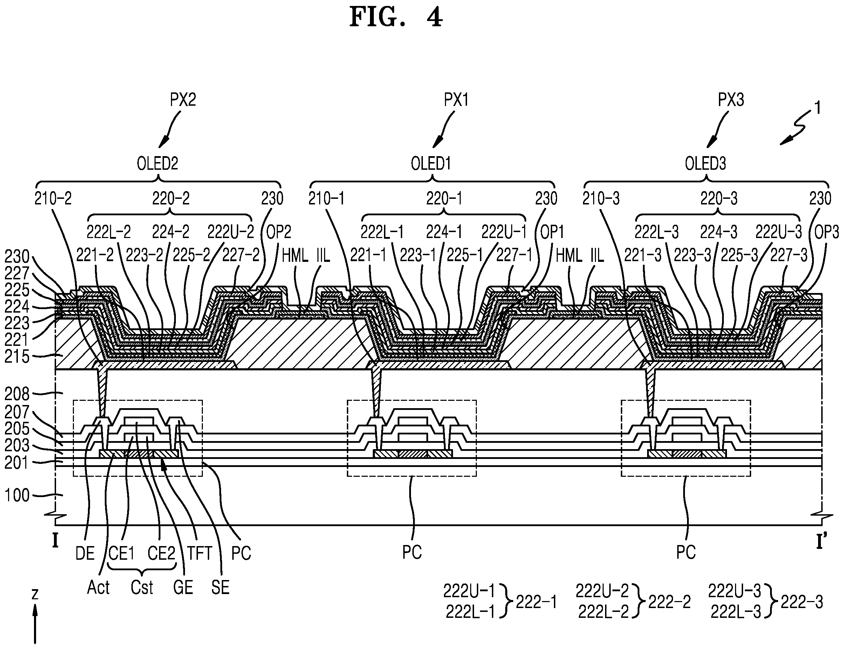

As illustrated in FIG. 1B, the display device 1 may include a display area DA in which a plurality of pixels PX are arranged and a peripheral area PA arranged outside the display area DA along an edge or periphery of the display area DA. More specifically, the peripheral area PA may entirely surround the display area DA. This may be understood as that a substrate 100 (see FIG. 4) included in the display device 1 has such display area DA and peripheral area PA.

Each pixel PX of the display device 1 may be an area emitting light of a certain color, and the display device 1 may provide an image by using light emitted from the pixels PX. For example, each pixel PX may emit green light, red light, or blue light.

The display area DA may have a polygonal shape including a quadrangular shape as shown in FIG. 1B. For example, the display area DA may have a rectangular shape having a horizontal length greater than a vertical length, a rectangular shape having a horizontal length less than a vertical length, or a square shape. Alternatively, the display area DA may have any of various shapes such as an elliptical shape or a circular shape.

The peripheral area PA may be a non-display area in which the pixels PX are not arranged. A driver, etc. to supply an electrical signal or power to the pixels PX may be arranged in the peripheral area PA. Pads to which various electronic elements, a printed circuit board (PCB), etc. may be connected may be arranged in the peripheral area PA. Each pad may be arranged spaced (e.g., arranged apart) from each other in the peripheral area PA and may be electrically connected to the printed circuit board (PCB) or an integrated circuit (IC) element.

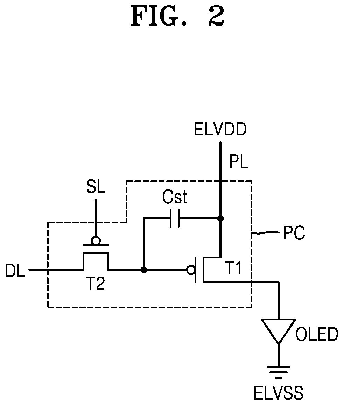

FIG. 2 is an equivalent circuit diagram of a pixel circuit PC included in the display device 1 according to one or more embodiments. The pixel circuit PC may be electrically connected to an organic light-emitting diode OLED, and the organic light-emitting diode OLED may correspond to a pixel PX.

The pixel circuit PC may include a first transistor T1, a second transistor T2, and a storage capacitor Cst. As a switching transistor, the second transistor T2 may be connected to a scan line SL and a data line DL and may be turned on by a switching signal input from the scan line SL and transmit a data signal input from the data line DL to the first transistor T1. The storage capacitor Cst may be electrically connected to the second transistor T2 at one end and to a driving voltage line PL at another end and may store a voltage corresponding to a difference between a voltage received from the second transistor T2 and a driving power voltage ELVDD supplied to the driving voltage line PL.

The first transistor T1, as a driving transistor, may be connected to the driving voltage line PL and the storage capacitor Cst and may control a level of a driving current flowing from the driving voltage line PL to the organic light-emitting diode OLED according to a voltage value stored in the storage capacitor Cst. The organic light-emitting diode OLED may emit light with a certain brightness according to the driving current. An opposite electrode of the organic light-emitting diode OLED may receive an electrode power voltage ELVSS.

FIG. 2 illustrates that the pixel circuit PC includes two transistors T1, T2 and one storage capacitor Cst; however, the present disclosure is not limited thereto. For example, the number of transistors and the number of storage capacitors may be variously changed depending on the design of the pixel circuit PC as a person of ordinary skill in the art would appreciate.

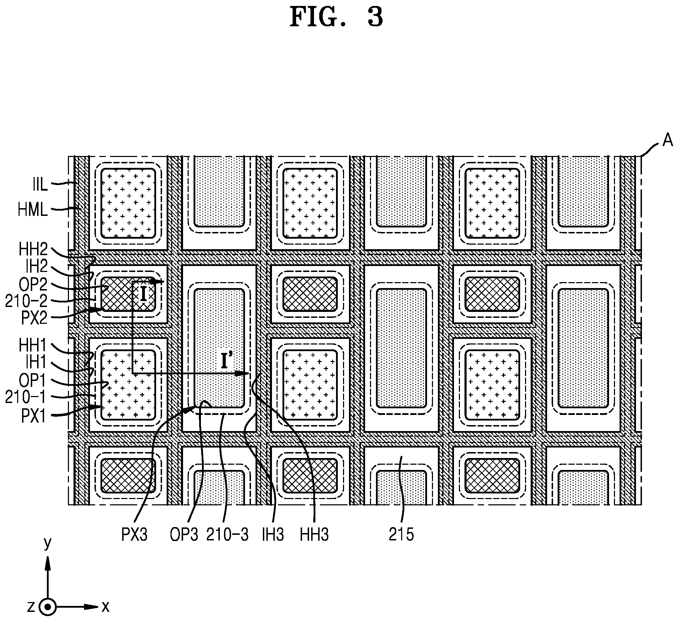

FIG. 3 is an enlarged plan view schematically illustrating a part A of the display device 1 of FIG. 1B. FIG. 3 illustrates a plan view on a pixel-defining layer 215 for convenience. However, a heating metal layer HML and an inorganic insulating layer IIL disposed on the pixel-defining layer 215 are also illustrated in FIG. 3 for convenience in description.

As illustrated in FIG. 3, a plurality of the pixels PX (see e.g. FIG. 1B) may be arranged in the display area DA of the substrate 100. Each pixel PX may be a subpixel and may include a display element such as an organic light-emitting diode OLED. The pixel PX may emit, for example, green light, red light, or blue light. For example, the pixels PX may be a first pixel PX1 emitting green light, a second pixel PX2 emitting red light, or a third pixel PX3 emitting blue light. The green light may be light having a wavelength band from about 495 nm to about 580 nm, the red light may be light having a wavelength band from about 580 nm to about 780 nm, and the blue light may be light having a wavelength band from about 400 nm to about 495 nm.

A first pixel electrode 210-1 included in the first pixel PX1, a second pixel electrode 210-2 included in the second pixel PX2, and a third pixel electrode 210-3 included in the third pixel PX3 may be arranged in the display area DA. For example, the first pixel electrode 210-1, the second pixel electrode 210-2, and the third pixel electrode 210-3 may be arranged spaced (e.g., arranged apart) from each other on a plane. The expression "on a plane" in the present disclosure may be used to describe the case in which an element is seen in a direction perpendicular to the substrate 100. That is, "A and B arranged spaced (e.g., arranged apart) from each other on a plane" may mean "A and B arranged spaced (e.g., arranged apart) from each other in a direction perpendicular to the substrate 100. The first pixel electrode 210-1, the second pixel electrode 210-2, and the third pixel electrode 210-3 may have different sizes from each other as illustrated in FIG. 3. In one or more embodiments, the first pixel electrode 210-1, the second pixel electrode 210-2, and the third pixel electrode 210-3 may have the same size.

The pixel-defining layer 215 may be disposed on the first pixel electrode 210-1, the second pixel electrode 210-2, and the third pixel electrode 210-3 and may include a first opening OP1, a second opening OP2, and a third opening OP3. In other words, the pixel-defining layer 215 may include an inner surface defining the first opening OP1, an inner surface defining the second opening OP2, and an inner surface defining the third opening OP3.

The first opening OP1 may expose a central portion of the first pixel electrode 210-1, the second opening OP2 may expose a central portion of the second pixel electrode 210-2, and the third opening OP3 may expose a central portion of the third pixel electrode 210-3. The first opening OP1, the second opening OP2, and the third opening OP3 may have different sizes from each other as illustrated in FIG. 3. In one or more embodiments, the first opening OP1, the second opening OP2, and the third opening OP3 may have the same size. Although FIG. 3 illustrates that each of the first opening OP1, the second opening OP2, and the third opening OP3 has a quadrangular shape, the present disclosure is not limited thereto. For example, each of the first opening OP1, the second opening OP2, and the third opening OP3 may have a hexagonal shape.

In one or more embodiments, emission layers emitting light may be arranged in each of the first opening OP1, the second opening OP2, and the third opening OP3 of the pixel-defining layer 215. An opposite electrode may be disposed on the emission layers. A stacked structure including a pixel electrode, an interlayer including an emission layer, and an opposite electrode may form an organic light-emitting diode OLED. One opening of the pixel-defining layer 215 may correspond to one organic light-emitting diode OLED and may define one emission area.

For example, an emission layer emitting green light may be arranged in the first opening OP1, and the first pixel PX1 may be an emission area defined by the first opening OP1. Similarly, an emission layer emitting red light may be arranged in the second opening OP2, and the second pixel PX2 may be an emission area defined by the second opening OP2. Similarly, an emission layer emitting blue light may be arranged in the third opening OP3, and the third pixel PX3 may be an emission area defined by the third opening OP3. However, the present disclosure is not limited thereto. For example, an emission layer emitting blue light, green light, or white light may be arranged in the first opening OP1, the second opening OP2, and the third opening OP3. In such a case, the display device 1 may include an emission panel and a color panel that are stacked in a thickness direction (e.g., z-axis direction) and blue light, green light, or white light emitted from an emission layer of the emission panel may pass through the color panel to be converted into green light, red light, and blue light, and/or to be transmitted.

The first opening OP1 and the second opening OP2 may be arranged adjacent to each other in a second direction (e.g., y direction or -y direction) intersecting with a first direction (e.g., x direction or -x direction), and the first opening OP1 and the third opening OP3 may be arranged adjacent to each other in the first direction (e.g., x direction or -x direction). As illustrated in FIG. 3, each of the size of the first opening OP1 and the size of the second opening OP2 may be smaller than the size of the third opening OP3, and as the second opening OP2 is arranged adjacent to the first opening OP1 in the second direction (e.g., y direction or -y direction), the third opening OP3 and the second opening OP2 may be arranged adjacent to each other in the first direction (e.g., x direction or -x direction).

The heating metal layer HML may be disposed on the pixel-defining layer 215. More specifically, when seen from a direction perpendicular to the substrate 100 (e.g., z direction or -z direction), the heating metal layer HML may be disposed on the pixel-defining layer 215 to surround each of the openings included in the pixel-defining layer 215, for example, the first opening OP1, the second opening OP2, and the third opening OP3. That is, the heating metal layer HML may have a mesh structure. In other words, the first opening OP1 may be arranged in a first heating metal hole HH1 defined by the heating metal layer HML on a plane. Similarly, the second opening OP2 may be arranged in a second heating metal hole HH2 defined by the heating metal layer HML on a plane, and the third opening OP3 may be arranged in a third heating metal hole HH3 defined by the heating metal layer HML on a plane. Accordingly, the heating metal layer HML may be arranged between neighboring openings (or pixels).

Although FIG. 3 illustrates that each of the first heating metal hole HH1, the second heating metal hole HH2, and the third heating metal hole HH3 has a rectangular shape, the present disclosure is not limited thereto. For example, the first heating metal hole HH1, the second heating metal hole HH2, and/or the third heating metal hole HH3 may have a polygonal shape including a quadrangular shape. That is, the first heating metal hole HH1, the second heating metal hole HH2, and/or the third heating metal hole HH3 may have a rectangular shape having a horizontal length greater than a vertical length, a rectangular shape having a horizontal length less than a vertical length, or a square shape. Alternatively, the first heating metal hole HH1, the second heating metal hole HH2, and/or the third heating metal hole HH3 may have various shapes including an elliptical shape or a circular shape.

Although FIG. 3 illustrates that heating metal layer HML entirely surround each of the openings included in the pixel-defining layer 215, i.e., the first opening OP1, the second opening OP2, and the third opening OP3, the present disclosure is not limited thereto. For example, the heating metal layer HML may partially surround each of the openings included in the pixel-defining layer 215, i.e., the first opening OP1, the second opening OP2, and the third opening OP3. More specifically, the heating metal layer HML may surround other portions of one opening except for one side of the opening. Accordingly, the heating metal layer HML may have a "U" shape on a plane.

The inorganic insulating layer IIL may cover the heating metal layer HML. More specifically, the inorganic insulating layer IIL may cover an upper surface and a lateral surface of the heating metal layer HML. That is, at least a part of the inorganic insulating layer IIL may be disposed on the heating metal layer HML. More specifically, when seen from the direction perpendicular to the substrate 100 (e.g., z direction or -z direction), at least a part of the inorganic insulating layer IIL may be disposed on the pixel-defining layer 215 to overlap the heating metal layer HML.

The inorganic insulating layer IIL may have the same shape as the pixel-defining layer 215, for example, the mesh structure. Accordingly, when seen from a direction perpendicular to the substrate 100 (e.g., z direction or -z direction), the inorganic insulating layer IIL may surround each of the openings included in the pixel-defining layer 215, i.e., the first opening OP1, the second opening OP2, and the third opening OP3. In other words, the first opening OP1 may be arranged in a first inorganic insulating hole IH1 defined by the inorganic insulating layer IIL on a plane. Similarly, the second opening OP2 may be arranged in a second inorganic insulating hole IH2 defined by the inorganic insulating layer IIL on a plane, and the third opening OP3 may be arranged in a third inorganic insulating hole IH3 defined by the inorganic insulating layer IIL on a plane. Accordingly, the inorganic insulating layer IIL may be arranged between neighboring openings (or pixels).

The first inorganic insulating hole IH1 may be smaller than the first heating metal hole HH1. More specifically, a width of the first inorganic insulating hole IH1 in one direction may be less than a width of the first heating metal hole HH1 in one direction. For example, a width of the first inorganic insulating hole IH1 in the first direction (e.g., x direction or -x direction) may be less than a width of the first heating metal hole HH1 in the first direction (e.g., x direction or -x direction), and a width of the first inorganic insulating hole IH1 in the second direction (e.g., y direction or -y direction) may be less than a width of the first heating metal hole HH1 in the second direction (e.g., y direction or -y direction).

Similarly, the second inorganic insulating hole IH2 may be smaller than the second heating metal hole HH2, and the third inorganic insulating hole IH3 may be smaller than the third heating metal hole HH3. More specifically, a width of the second inorganic insulating hole IH2 in one direction may be less than a width of the second heating metal hole HH2 in one direction, and a width of the third inorganic insulating hole IH3 in one direction may be less than a width of the third heating metal hole HH3 in one direction. For example, a width of the second inorganic insulating hole IH2 in the first direction (e.g., x direction or -x direction) may be less than a width of the second heating metal hole HH2 in the first direction (e.g., x direction or -x direction), and a width of the second inorganic insulating hole IH2 in the second direction (e.g., y direction or -y direction) may be less than a width of the second heating metal hole HH2 in the second direction (e.g., y direction or -y direction). A width of the third inorganic insulating hole IH3 in the first direction (e.g., x direction or -x direction) may be less than a width of the third heating metal hole HH3 in the first direction (e.g., x direction or -x direction), and a width of the third inorganic insulating hole IH3 in the second direction (e.g., y direction or -y direction) may be less than a width of the third heating metal hole HH3 in the second direction (e.g., y direction or -y direction).

Although FIG. 3 illustrates that each of the first inorganic insulating hole IH1, the second inorganic insulating hole IH2, and the third inorganic insulating hole IH3 has a rectangular shape, the present disclosure is not limited thereto. For example, the first inorganic insulating hole IH1, the second inorganic insulating hole IH2, and/or the third inorganic insulating hole IH3 may have a polygonal shape including a quadrangular shape. That is, the first inorganic insulating hole IH1, the second inorganic insulating hole IH2, and/or the third inorganic insulating hole IH3 may have a rectangular shape having a horizontal length greater than a vertical length, a rectangular shape having a horizontal length less than a vertical length, or a square shape. Alternatively, the first inorganic insulating hole IH1, the second inorganic insulating hole IH2, and/or the third inorganic insulating hole IH3 may have various shapes including an elliptical shape or a circular shape.

Although FIG. 3 illustrates that the plurality of pixels PX are arranged in a stripe type, the pixels PX may be arranged in various shapes such as a RGBG type (e.g., a PENTILE^{®} structure, and/or the like), etc. PENTILE^{®} is a registered trademark of Samsung Display Co., Ltd., Republic of Korea.

FIG. 4 is a cross-sectional view of a portion of the display device 1 according to one or more embodiments. More specifically, FIG. 4 is a cross-sectional view schematically illustrating the display device 1 of FIG. 3 taken along the line I-I' of FIG. 3.

As illustrated in FIG. 4, the display device 1 according to one or more embodiments may include the substrate 100. The substrate 100 may include various materials having flexible or bendable characteristics. For example, the substrate 100 may include a glass, a metal, and/or a polymer resin. For example, the substrate 100 may include a polymer resin such as polyethersulfone, polyacrylate, polyetherimide, polyethylene naphthalate, polyethylene terephthalate, polyphenylene sulfide, polyarylate, PI, polycarbonate or cellulose acetate propionate. The substrate 100 may be changed in various ways. For example, the substrate 100 may have a multi-layer structure including two layers including the aforementioned polymer resin and a barrier layer arranged therebetween and including an inorganic material (silicon oxide (SiOx), silicon nitride (SiN_{X}), and/or silicon oxynitride (SiO_{X}N_{Y}), etc.).

A display element included in the pixel PX and the pixel circuit PC electrically connected to the display element may be disposed on the substrate 100. FIG. 4 illustrates that the pixel PX includes the organic light-emitting diode OLED as a display element. For example, the organic light-emitting diode OLED may be a first organic light-emitting diode OLED1, a second organic light-emitting diode OLED2, and/or a third organic light-emitting diode OLED3. That is, the first pixel PX1 may include the first organic light-emitting diode OLED1, the second pixel PX2 may include the second organic light-emitting diode OLED2, and the third pixel PX3 may include the third organic light-emitting diode OLED3.

The pixel circuit PC may be disposed on the substrate 100. As the structure of the pixel circuit PC of each pixel PX is identical, embodiments are described focusing on one pixel circuit PC. The pixel circuit PC may include a plurality of thin-film transistors TFT and a storage capacitor Cst. FIG. 4 illustrates one thin-film transistor TFT for convenience of description. The thin-film transistor TFT may correspond to the first transistor T1 (see FIG. 2).

A buffer layer 201 including an inorganic material such as silicon oxide (SiO_{X}), silicon nitride (SiN_{X}), and/or silicon oxynitride (SiO_{X}N_{Y}) may be interposed between the thin-film transistor TFT and the substrate 100. The buffer layer 201 may increase smoothness of an upper surface of the substrate 100 or prevent or minimize penetration of impurities from the substrate 100, etc. into a semiconductor layer Act of the thin-film transistor TFT.

As illustrated in FIG. 4, the thin-film transistor TFT may include the semiconductor layer Act including amorphous silicon, polycrystalline silicon, organic semiconductor material, or oxide semiconductor material. The semiconductor layer Act of the thin-film transistor TFT may be on the buffer layer 201. The thin-film transistor TFT may include a gate electrode GE, a source electrode SE, and/or a drain electrode DE. The gate electrode GE may include various conductive materials and have various layer structures. For example, the gate electrode GE may include a Mo layer and an Al layer. Alternatively, the gate electrode GE may include a TiNx layer, an Al layer, and/or a Ti layer. The source electrode SE and the drain electrode DE may also include various conductive materials and have various layer structures. For example, the source electrode SE and the drain electrode DE may include a Ti layer, an Al layer, and/or a Cu layer.

A gate insulating layer 203 including an inorganic material such as a silicon oxide (SiO_{X}), a silicon nitride (SiN_{X}), and/or a silicon oxynitride (SiO_{X}N_{Y}) may be interposed between the semiconductor layer Act and the gate electrode GE to secure insulation between the semiconductor layer Act and the gate electrode GE. The gate insulating layer 203 may be disposed on the buffer layer 201 and the semiconductor layer Act. FIG. 4 illustrates that the gate insulating layer 203 has a shape corresponding to an entire surface of the substrate 100 and has a structure in which contact holes are formed at a preset portion; however, the present disclosure is not limited thereto. For example, the gate insulating layer 203 may be patterned into the same shape as the gate electrode GE.

Moreover, a first interlayer insulating layer 205 including an inorganic material such as a silicon oxide (SiOx), a silicon nitride (SiNx), and/or a silicon oxynitride (SiO_{X}N_{Y}) may be disposed on the gate electrode GE and the gate insulating layer 203. The first interlayer insulating layer 205 may have a single-layer or multi-layer structure including the aforementioned material. Such an insulating film including an inorganic material may be formed through chemical vapor deposition (CVD) or atomic layer deposition (ALD). This may apply to the following embodiments and modifications as well.

The storage capacitor Cst may include a first capacitor electrode CE1 and a second capacitor electrode CE2 overlapping each other in the z direction with the first interlayer insulating layer 205 therebetween. The storage capacitor Cst may overlap the thin film transistor TFT (e.g., the semiconductor layer Act of the thin-film transistor TFT) in the z direction. In this regard, FIG. 4 illustrates that the gate electrode GE of the thin-film transistor TFT is the first capacitor electrode CE1 of the storage capacitor Cst; however, the present disclosure is not limited thereto. For example, the storage capacitor Cst may not overlap the thin-film transistor TFT. The second capacitor electrode CE2 of the storage capacitor Cst may include a conductive material including molybdenum (Mo), aluminum (Al), copper (Cu), and/or titanium (Ti), etc., and may have a single-layer or multi-layer structure including the aforementioned material.

A second interlayer insulating layer 207 including an inorganic material such as silicon oxide (SiO_{X}), silicon nitride (SiN_{X}), and/or silicon oxynitride (SiO_{X}N_{Y}) may be disposed on the second capacitor electrode CE2 of the storage capacitor Cst and the first interlayer insulating layer 205. The second interlayer insulating layer 207 may have a single-layer or multi-layer structure including the aforementioned material.

The source electrode SE and the drain electrode DE may be disposed on the second interlayer insulating layer 207. The source electrode SE and the drain electrode DE may include a material having excellent conductivity. The source electrode SE and the drain electrode DE may include a conductive material including molybdenum (Mo), aluminum (Al), copper (Cu), and/or titanium (Ti), etc. and have a single-layer or multi-layer structure including the above materials. For example, the source electrode SE and the drain electrode DE may have a multi-layer structure of Ti/Al/Ti.

However, the present disclosure is not limited thereto. For example, the thin-film transistor TFT may include any one of the source electrode SE and the drain electrode DE or may not include both of the source electrode SE and the drain electrode DE. For example, one thin-film transistor TFT may not include a drain electrode DE, another thin-film transistor TFT connected to the thin-film transistor TFT may not include a source electrode SE, and semiconductor layers Act of the two thin-film transistors may be connected to each other. Such connection structure may have the same effect as a connection structure in which one thin-film transistor TFT includes a source electrode SE, another thin-film transistor TFT includes a drain electrode DE, and the source electrode SE of one thin-film transistor TFT is connected to the drain electrode DE of another thin-film transistor TFT.

As illustrated in FIG. 4, a planarization layer 208 may be arranged to cover the thin-film transistor TFT and the storage capacitor Cst. The planarization layer 208 may include an organic insulating material. For example, the planarization layer 208 may include photoresist, benzocyclobutene (BCB), polyimide, hexamethyldisiloxane (HMDSO), polymethylmethacrylate (PMMA), polystyrene, a polymer derivative having a phenol-based group, an acryl-based polymer, an imide-based polymer, an aryl ether-based polymer, an amide-based polymer, a fluorine-based polymer, a p-xylene-based polymer, a vinyl alcohol-based polymer, and/or any blends thereof. In one or more embodiments, a third interlayer insulating layer may be further disposed under the planarization layer 208. The third interlayer insulating layer may include an inorganic insulating material such as a silicon oxide (SiOx), a silicon nitride (SiNx), and/or a silicon oxynitride (SiO_{X}N_{Y}).

FIG. 4 illustrates that the pixel circuit PC is formed on the substrate 100. More specifically, the buffer layer 201 may be disposed on the substrate 100, the semiconductor layer Act may be disposed on the buffer layer 201, the gate insulating layer 203 may be disposed on the semiconductor layer Act, and the gate electrode GE may be disposed on the gate insulating layer 203. The first interlayer insulating layer 205 may be disposed on the gate electrode GE, the second capacitor electrode CE2 may be disposed on the first interlayer insulating layer 205, and the second interlayer insulating layer 207 may be disposed on the second capacitor electrode CE2. The source electrode SE and the drain electrode DE may be disposed on the second interlayer insulating layer 207, and the planarization layer 208 may be disposed on the source electrode SE and the drain electrode DE. Accordingly, the pixel circuit PC may be formed on the substrate 100.

However, the present disclosure is not limited thereto. For example, the display device 1 may include a complementary metal-oxide semiconductor (CMOS) circuit formed by using a semiconductor process. One organic light-emitting diode OLED may be electrically connected to one CMOS circuit. In other words, one organic light-emitting diode OLED may be electrically connected to a plurality of transistors and a capacitor formed by using a semiconductor process. In this case, the substrate 100 may include a silicon substrate (e.g., a silicon semiconductor substrate). For example, the substrate 100 may be a silicon wafer. The silicon wafer may be a monocrystalline silicon wafer, a polycrystalline silicon wafer, or an amorphous silicon wafer.

The first organic light-emitting diode OLED1, the second organic light-emitting diode OLED2, and the third organic light-emitting diode OLED3 may be arranged spaced (e.g., arranged apart) from each other on the planarization layer 208. More specifically, the first organic light-emitting diode OLED1 and the second organic light-emitting diode OLED2 which are adjacent to each other in the second direction (e.g., y direction or -y direction) intersecting with the first direction (e.g., x direction or -x direction) may be disposed on the planarization layer 208, and the third organic light-emitting diode OLED3 may be disposed on the planarization layer 208 to be adjacent to the first organic light-emitting diode OLED1 in the first direction (e.g., x direction or -x direction). The first organic light-emitting diode OLED1, the second organic light-emitting diode OLED2, and the third organic light-emitting diode OLED3 may emit light of different colors from each other. For example, the first organic light-emitting diode OLED1 may emit green light, the second organic light-emitting diode OLED2 may emit red light, and the third organic light-emitting diode OLED3 may emit blue light.

The first organic light-emitting diode OLED1 may include a first pixel electrode 210-1, a first intermediate layer 220-1, and an opposite electrode 230. The second organic light-emitting diode OLED2 may include a second pixel electrode 210-2, a second intermediate layer 220-2, and an opposite electrode 230. The third organic light-emitting diode OLED3 may include a third pixel electrode 210-3, a third intermediate layer 220-3, and an opposite electrode 230. The opposite electrode 230 may be provided in an integrated manner over the entire surface of the display device 1, and accordingly, may be provided commonly to a plurality of organic light-emitting diodes.

The first pixel electrode 210-1 and the second pixel electrode 210-2 may be arranged spaced (e.g., arranged apart) from each other on the planarization layer 208. More specifically, the second pixel electrode 210-2 may be disposed on the planarization layer 208 to be adjacent to the first pixel electrode 210-1 in the second direction (e.g., y direction or -y direction). The third pixel electrode 210-3 may be arranged spaced (e.g., arranged apart) from the first pixel electrode 210-1 on the planarization layer 208. More specifically, the third pixel electrode 210-3 may be disposed on the planarization layer 208 to be adjacent to the first pixel electrode 210-1 in the first direction (e.g., x direction or -x direction).

The first pixel electrode 210-1, the second pixel electrode 210-2, and the third pixel electrode 210-3 may include a transparent conductive layer including a transparent conductive oxide such as ITO, In₂O₃, and/or IZO, etc. and/or a reflective layer including a metal such as Al, and/or Ag, etc. For example, the first pixel electrode 210-1, the second pixel electrode 210-2, and the third pixel electrode 210-3 may have a triple-layer structure of ITO/Ag/ITO. In one or more embodiments, the first pixel electrode 210-1, the second pixel electrode 210-2, and the third pixel electrode 210-3 may be a single layer or multi layers including TiNx

The first pixel electrode 210-1, the second pixel electrode 210-2, and the third pixel electrode 210-3 may be in contact with any one of the source electrode SE and the drain electrode DE as illustrated in FIG. 4 and may be electrically connected to the thin-film transistor TFT. More specifically, each of the first pixel electrode 210-1, the second pixel electrode 210-2, and the third pixel electrode 210-3 may be in contact with any one of the source electrode SE and the drain electrode DE through a contact hole formed in the planarization layer 208.

The pixel-defining layer 215 may be disposed on the planarization layer 208. The pixel-defining layer 215 may define a pixel PX by including an opening corresponding to the pixel PX, i.e., an opening at least exposing a central portion of a pixel electrode. More specifically, the pixel-defining layer 215 may include the first opening OP1, the second opening OP2, and the third opening OP3. The first opening OP1 may expose a central portion of the first pixel electrode 210-1, the second opening OP2 may expose a central portion of the second pixel electrode 210-2, and the third opening OP3 may expose a central portion of the third pixel electrode 210-3.

In addition, in the case illustrated in FIG. 4, the pixel-defining layer 215 may increase a distance between an edge of the first pixel electrode 210-1 and the opposite electrode 230 on the first pixel electrode 210-1. Similarly, the pixel-defining layer 215 may increase a distance between an edge of the second pixel electrode 210-2 and the opposite electrode 230 on the second pixel electrode 210-2 and may increase a distance between an edge of the third pixel electrode 210-3 and the opposite electrode 230 on the third pixel electrode 210-3. This may prevent occurrence of an arc, etc. at the edge of the first pixel electrode 210-1, the edge of the second pixel electrode 210-2, and the edge of the third pixel electrode 210-3. The pixel-defining layer 215 may include an organic material such as polyimide, hexamethyldisiloxane (HMDSO), etc. In one or more embodiments, the pixel-defining layer 215 may include an inorganic material such as a silicon oxide (SiOx), a silicon nitride (SiNx), etc.

The first intermediate layer 220-1 may be disposed on the first pixel electrode 210-1. The second intermediate layer 220-2 may be disposed on the second pixel electrode 210-2, and the third intermediate layer 220-3 may be disposed on the third pixel electrode 210-3.

The intermediate layers may respectively include emission layers capable of emitting light having different wavelength bands from each other. More specifically, the first intermediate layer 220-1 may include a first emission layer 222-1, and the first emission layer 222-1 may emit green light. The second intermediate layer 220-2 may include a second emission layer 222-2, and the second emission layer 222-2 may emit red light. The third intermediate layer 220-3 may include a third emission layer 222-3, and the third emission layer 222-3 may emit blue light. The green light may be light having a wavelength band from about 495 nm to about 580 nm, the red light may be light having a wavelength band from about 580 nm to about 780 nm, and the blue light may be light having a wavelength band from about 400 nm to about 495 nm.

Each emission layer may include a high-molecular or low-molecular weight organic material for emitting light of a certain color. That is, the first emission layer 222-1 may be formed by using, for example, a green dopant to a certain host material. The second emission layer 222-2 may be formed by using, for example, a red dopant to a certain host material, and the third emission layer 222-3 may be formed by using, for example, a blue dopant to a certain host material.

Each organic light-emitting diode OLED may have a tandem structure. More specifically, the first organic light-emitting diode OLED1 may include a first lower emission layer 222L-1 and a first upper emission layer 222U-1, and the first upper emission layer 222U-1 may be disposed on the first lower emission layer 222L-1 to overlap the first lower emission layer 222L-1 in the z-direction. That is, the first emission layer 222-1 may include the first lower emission layer 222L-1 and the first upper emission layer 222U-1. The first lower emission layer 222L-1 may be disposed on the first pixel electrode 210-1 and the first upper emission layer 222U-1 may be disposed on the first lower emission layer 222L-1.

The second organic light-emitting diode OLED2 may include a second lower emission layer 222L-2 and a second upper emission layer 222U-2, and the second upper emission layer 222U-2 may be disposed on the second lower emission layer 222L-2 to overlap the second lower emission layer 222L-2 in the z-direction. That is, the second emission layer 222-2 may include the second lower emission layer 222L-2 and the second upper emission layer 222U-2. The second lower emission layer 222L-2 may be disposed on the second pixel electrode 210-2, and the second upper emission layer 222U-2 may be disposed on the second lower emission layer 222L-2. The third organic light-emitting diode OLED3 may include a third lower emission layer 222L-3 and a third upper emission layer 222U-3, and the third upper emission layer 222U-3 may be disposed on the third lower emission layer 222L-3 to overlap the third lower emission layer 222L-3. That is, the third emission layer 222-3 may include the third lower emission layer 222L-3 and the third upper emission layer 222U-3. The third lower emission layer 222L-3 may be disposed on the third pixel electrode 210-3, and the third upper emission layer 222U-3 may be disposed on the third lower emission layer 222L-3.

Each intermediate layer may further include a charge generation layer 224, a first common layer 221, a second common layer 223, a third common layer 225, and a fourth common layer 227. More specifically, each intermediate layer may further include a part of the charge generation layer 224, a part of the first common layer 221, a part of the second common layer 223, a part of the third common layer 225, and a part of the fourth common layer 227.

The charge generation layer 224 may be interposed between lower emission layers and the upper emission layers. The charge generation layer 224 may supply charges to a first stack including the lower emission layers and a second stack including the upper emission layers. The charge generation layer 224 may include an n-type charge generation layer n-CGL supplying electrons to the first stack and a p-type charge generation layer p-CGL supplying holes to the second stack.

More specifically, the charge generation layer 224 may include a first charge generation layer 224-1, a second charge generation layer 224-2, and a third charge generation layer 224-3. The first charge generation layer 224-1 may be interposed between the first lower emission layer 222L-1 and the first upper emission layer 222U-1. The second charge generation layer 224-2 may be interposed between the second lower emission layer 222L-2 and the second upper emission layer 222U-2, and the third charge generation layer 224-3 may be interposed between the third lower emission layer 222L-3 and the third upper emission layer 222U-3. That is, the first charge generation layer 224-1, the second charge generation layer 224-2, and the third charge generation layer 224-3 may be a part of the charge generation layer 224. In other words, the first charge generation layer 224-1 the second charge generation layer 224-2, and the third charge generation layer 224-3 may be a sub-charge generation layer.

The n-type charge generation layer n-CGL may include an n-type dopant material and an n-type host material. The n-type dopant material may be an organic material to which a metal of Group I or II or an electron may be injected, or any blends thereof. Alternatively, the n-type dopant material may include a rare earth metal such as scandium (Sc), yttrium (Y), and/or lanthanum (La), etc. For example, the n-type dopant material may be any one of alkali metals and alkali earth metals. That is, the n-type charge generation layer n-CGL may include an organic layer doped with an alkali metal such as lithium (Li), sodium (Na), and cesium (Cs) or an alkali earth metal such as magnesium (Mg), strontium (Sr), barium (Ba), and/or radium (Ra). However, the present disclosure is not limited thereto. The n-type host material may be a material capable of transporting electrons and include, for example, at least one of Alq₃(tris(8-hydroxyquinolino)aluminum), Liq(8-hydroxyquinolinolato-lithium), PBD(2-(4-biphenylyl)-5-(4-tert-butylphenyl)-1,3,4-oxadiazole), TAZ(3-(4-biphenyl)4-phenyl-5-tert-butylphenyl-1,2,4-triazole), spiro-PBD, BAIq(bis(2-methyl-8-quinolinolate)-4-(phenylphenolato)aluminium), SAlq, TPBi(2,2',2-(1,3,5-benzinetriyl)-tris(1-phenyl-1-H-benzimidazole)), oxadiazole, triazole, phenanthroline, benzoxazole, and/or benzthiazole. Alternatively, the n-type host material may include a compound including an oxadiazole group, a triazole group, a phenanthroline group, a benzoxazole group, and/or a benzthiazole group. However, the present disclosure is not limited thereto.

The p-type charge generation layer p-CGL may include a p-type dopant material and a p-type host material. The p-type dopant material may include an organic material such as tetrafluoro-tetracyanoquinodimethane (F4-TCNQ), hexaazatriphenylene-hexacarbonitrile (HAT-CN), hexaazatriphenylene, etc. and/or a metal material such as V₂O₅, MoOx, WOs, etc. However, the present disclosure is not limited thereto. The p-type host material may include a material capable of transporting holes including at least one of NPD(N,N-dinaphthyl-N,N'-diphenyl benzidine)(N,N'-bis(naphthalene-1-yl)-N,N'-bis(phenyl)-2,2'-dimethylbenzidine), TPD(N,N'-bis-(3-methylphenyl)-N,N'-bis-(phenyl)-benzidine), and/or MTDATA(4,4',4-tris(N-3-methylphenyl-N-phenyl-amino)-triphenylamine; however, the present disclosure is not limited thereto.

The first charge generation layer 224-1, the second charge generation layer 224-2, and the third charge generation layer 224-3 included in the charge generation layer 224 may be concurrently (e.g., simultaneously) formed of the same material through the same process. More specifically, a material forming the charge generation layer 224 may be deposited on the entire surface of the substrate 100. Then, by removing a part of the material forming the charge generation layer 224 and deposited on the entire surface of the substrate 100, the first charge generation layer 224-1, the second charge generation layer 224-2, and the third charge generation layer 224-3 may be formed. Accordingly, the first charge generation layer 224-1, the second charge generation layer 224-2, and the third charge generation layer 224-3 may include the same material.

The first common layer 221 may be interposed between the pixel electrodes and the lower emission layers. The first common layer 221 may include a 1-1 common layer 221-1, a 1-2 common layer 221-2, and a 1-3 common layer 221-3. More specifically, the 1-1 common layer 221-1 may be interposed between the first pixel electrode 210-1 and the first lower emission layer 222L-1. The 1-2 common layer 221-2 may be interposed between the second pixel electrode 210-2 and the second lower emission layer 222L-2, and the 1-3 common layer 221-3 may be interposed between the third pixel electrode 210-3 and the third lower emission layer 222L-3. That is, the 1-1 common layer 221-1, the 1-2 common layer 221-2, and the 1-3 common layer 221-3 may be a part of the first common layer 221. In other words, the 1-1 common layer 221-1, the 1-2 common layer 221-2, and the 1-3 common layer 221-3 may be a sub-common layer.

The first common layer 221 may have a single-layer structure or a multi-layer structure. For example, when the first common layer 221 is formed of a high-molecular weight material, the first common layer 221 may include a hole transport layer (HTL) having a single-layer structure. When the first common layer 221 is formed of a low-molecular weight material, the first common layer 221 may include a hole injection layer (HIL) and a hole transport layer (HTL).

The hole transport layer (HTL) may include as its host a triphenylamine derivative having high hole mobility and excellent stability, such as TPD(N, N'-diphenyl-N,N'-bis(3-methylphenyl)-1,1'-bi-phenyl-4,4'-diamine), and/or NPB(N,N'-di(naphthalen-1-yl)-N,N'-diphenyl-benzidine), etc. The hole injection layer (HIL) may facilitate injection of holes and may include at least one selected from a group consisting of HATCN, CuPc(copper phthalocyanine), PEDOT(poly(3,4)-ethylenedioxythiophene), PANI(polyaniline), and NPD(N, N-dinaphthyl-N, N'-diphenylbenzidine); however, the present disclosure is not limited thereto.

The 1-1 common layer 221-1, the 1-2 common layer 221-2, the 1-3 common layer 221-3 included in the first common layer 221 may be concurrently (e.g., simultaneously) formed of the same material through the same process. More specifically, a material forming the first common layer 221 may be deposited on the entire surface of the substrate 100. Then, by removing a part of the material forming the first common layer 221 and deposited on the entire surface of the substrate 100, the 1-1 common layer 221-1, the 1-2 common layer 221-2, and the 1-3 common layer 221-3 may be formed. Accordingly, the 1-1 common layer 221-1, the 1-2 common layer 221-2, and the 1-3 common layer 221-3 may include the same material.

The second common layer 223 may be interposed between the lower emission layer and the charge generation layer 224. The second common layer 223 may include a 2-1 common layer 223-1, a 2-2 common layer 223-2, and a 2-3 common layer 223-3. More specifically, the 2-1 common layer 223-1 may be interposed between the first lower emission layer 222L-1 and the first charge generation layer 224-1. The 2-2 common layer 223-2 may be interposed between the second lower emission layer 222L-2 and the second charge generation layer 224-2, and the 2-3 common layer 223-3 may be interposed between the third lower emission layer 222L-3 and the third charge generation layer 224-3. That is, the 2-1 common layer 223-1, the 2-2 common layer 223-2, and the 2-3 common layer 223-3 may be a part of the second common layer 223. In other words, the 2-1 common layer 223-1, the 2-2 common layer 223-2, and the 2-3 common layer 223-3 may be a sub-common layer.

The second common layer 223 may include an electron transport layer (ETL). The electron transport layer (ETL) may facilitate transport of electrons and may include at least one selected from a group consisting of Alq3(tris(8-hydroxyquinolino)aluminum), PBD, TAZ, spiro-PBD, BAlq, Liq(lithium quinolate), BMB-3T, PF-6P, TPBI, COT, and SAlq; however, the present disclosure is not limited thereto.

The 2-1 common layer 223-1, the 2-2 common layer 223-2, and the 2-3 common layer 223-3 included in the second common layer 223 may be concurrently (e.g., simultaneously) formed of the same material through the same process. More specifically, a material forming the second common layer 223 may be deposited on the entire surface of the substrate 100. Then, by removing a part of the material forming the second common layer 223 and deposited on the entire surface of the substrate 100, the 2-1 common layer 223-1, the 2-2 common layer 223-2, and the 2-3 common layer 223-3 may be formed. Accordingly, the 2-1 common layer 223-1, the 2-2 common layer 223-2, and the 2-3 common layer 223-3 may include the same material.

The third common layer 225 may be interposed between the charge generation layer 224 and the upper emission layers. The third common layer 225 may include a 3-1 common layer 225-1, a 3-2 common layer 225-2, and a 3-3 common layer 225-3. More specifically, the 3-1 common layer 225-1 may be interposed between the first charge generation layer 224-1 and the first upper emission layer 222U-1. The 3-2 common layer 225-2 may be interposed between the second charge generation layer 224-2 and the second upper emission layer 222U-2, and the 3-3 common layer 225-3 may be interposed between the third charge generation layer 224-3 and the third upper emission layer 222U-3. That is, the 3-1 common layer 225-1, the 3-2 common layer 225-2, and the 3-3 common layer 225-3 may be a part of the third common layer 225. In other words, the 3-1 common layer 225-1, the 3-2 common layer 225-2, and the 3-3 common layer 225-3 may be a sub-common layer.

The third common layer 225 may include a hole transport layer (HTL). The hole transport layer (HTL) may include as its host a triphenylamine derivative having high hole mobility and excellent stability, such as TPD(N, N'-diphenyl-N,N'-bis(3-methylphenyl)-1,1'-bi-phenyl-4,4'-diamine), and/or NPB(N,N'-di(naphthalen-1-yl)-N,N'-diphenyl-benzidine), etc.

The 3-1 common layer 225-1, the 3-2 common layer 225-2, and the 3-3 common layer 225-3 included in the third common layer 225 may be concurrently (e.g., simultaneously) formed of the same material through the same process. More specifically, a material forming the third common layer 225 may be deposited on the entire surface of the substrate 100. Then, by removing a part of the material forming the third common layer 225 and deposited on the entire surface of the substrate 100, the 3-1 common layer 225-1, the 3-2 common layer 225-2, and the 3-3 common layer 225-3 may be formed. Accordingly, the 3-1 common layer 225-1, the 3-2 common layer 225-2, and the 3-3 common layer 225-3 may include the same material. In one or more embodiments, a part of the material forming the third common layer 225 and deposited on the entire surface of the substrate 100 may not be removed.

The fourth common layer 227 may be disposed on the upper emission layers. The fourth common layer 227 may include a 4-1 common layer 227-1, a 4-2 common layer 227-2, and a 4-3 common layer 227-3. More specifically, the 4-1 common layer 227-1 may be disposed on the first upper emission layer 222U-1. The 4-2 common layer 227-2 may be disposed on the second upper emission layer 222U-2, and the 4-3 common layer 227-3 may be disposed on the third upper emission layer 222U-3. That is, the 4-1 common layer 227-1, the 4-2 common layer 227-2, and the 4-3 common layer 227-3 may be a part of the fourth common layer 227. In other words, the 4-1 common layer 227-1, the 4-2 common layer 227-2, and the 4-3 common layer 227-3 may be a sub-common layer.

The fourth common layer 227 may include an electron transport layer (ETL). The electron transport layer (ETL) may facilitate transport of electrons and may include at least one selected from a group consisting of Alq3(tris(8-hydroxyquinolino)aluminum), PBD, TAZ, spiro-PBD, BAlq, Liq(lithium quinolate), BMB-3T, PF-6P, TPBI, COT, and SAlq; however, the present disclosure is not limited thereto. In one or more embodiments, the fourth common layer 227 may further include an electron injection layer (EIL). The electron injection layer (EIL) may facilitate injection of electrons and may use Yb, Alq3(tris(8-hydroxyquinolino)aluminum), PBD, TAZ, spiro-PBD, BAlq, and/or SAlq; however, the present disclosure is not limited thereto.

The 4-1 common layer 227-1, the 4-2 common layer 227-2, and the 4-3 common layer 227-3 included in the fourth common layer 227 may be concurrently (e.g., simultaneously) formed of the same material through the same process. More specifically, a material forming the fourth common layer 227 may be deposited on the entire surface of the substrate 100. Then, by removing a part of the material forming the fourth common layer 227 and deposited on the entire surface of the substrate 100, the 4-1 common layer 227-1, the 4-2 common layer 227-2, and the 4-3 common layer 227-3 may be formed. Accordingly, the 4-1 common layer 227-1, the 4-2 common layer 227-2, and the 4-3 common layer 227-3 may include the same material. In one or more embodiments, a part of the material forming the fourth common layer 227 and deposited on the entire surface of the substrate 100 may not be removed.

In other words, the first intermediate layer 220-1 of the first organic light-emitting diode OLED1 may include the 1-1 common layer 221-1, the first lower emission layer 222L-1, the 2-1 common layer 223-1, the first charge generation layer 224-1, the 3-1 common layer 225-1, the first upper emission layer 222U-1, and the 4-1 common layer 227-1. The first intermediate layer 220-1 may have a structure in which the 1-1 common layer 221-1, the first lower emission layer 222L-1, the 2-1 common layer 223-1, the first charge generation layer 224-1, the 3-1 common layer 225-1, the first upper emission layer 222U-1, and the 4-1 common layer 227-1 are stacked in this stated order.

Similarly, the second intermediate layer 220-2 of the second organic light-emitting diode OLED2 may include the 1-2 common layer 221-2, the second lower emission layer 222L-2, the 2-2 common layer 223-2, the second charge generation layer 224-2, the 3-2 common layer 225-2, the second upper emission layer 222U-2, and the 4-2 common layer 227-2. The second intermediate layer 220-2 may have a structure in which the 1-2 common layer 221-2, the second lower emission layer 222L-2, the 2-2 common layer 223-2, the second charge generation layer 224-2, the 3-2 common layer 225-2, the second upper emission layer 222U-2, and the 4-2 common layer 227-2 are stacked in this stated order. The third intermediate layer 220-3 of the third organic light-emitting diode OLED3 may include the 1-3 common layer 221-3, the third lower emission layer 222L-3, the 2-3 common layer 223-3, the third charge generation layer 224-3, the 3-3 common layer 225-3, the third upper emission layer 222U-3, and the 4-3 common layer 227-3. The third intermediate layer 220-3 may have a structure in which the 1-3 common layer 221-3, the third lower emission layer 222L-3, the 2-3 common layer 223-3, the third charge generation layer 224-3, the 3-3 common layer 225-3, the third upper emission layer 222U-3, and the 4-3 common layer 227-3 are stacked in this stated order.

FIG. 4 illustrates that each of the first organic light-emitting diode OLED1, the second organic light-emitting diode OLED2, and the third organic light-emitting diode OLED3 includes the first common layer 221, the second common layer 223, the third common layer 225, and the fourth common layer 227; however, the present disclosure is not limited thereto. In one or more embodiments, at least one of the first common layer 221, the second common layer 223, the third common layer 225, and the fourth common layer 227 may be omitted.

The layers included in the first intermediate layer 220-1, the layers included in the second intermediate layer 220-2, and the layers included in the third intermediate layer 220-3 may be arranged spaced (e.g., arranged apart) from each other. More specifically, the first charge generation layer 224-1, the second charge generation layer 224-2, and the third charge generation layer 224-3 may be arranged spaced (e.g., arranged apart) from each other. As described above, as the first charge generation layer 224-1, the second charge generation layer 224-2, and the third charge generation layer 224-3 may be formed by removing a part of the material forming the charge generation layer 224 and deposited on the entire surface of the substrate 100, the first charge generation layer 224-1, the second charge generation layer 224-2, and the third charge generation layer 224-3 may be spaced from each other.

Similarly, the 1-1 common layer 221-1, the 1-2 common layer 221-2, and the 1-3 common layer 221-3 may be arranged spaced (e.g., arranged apart) from each other, and the 2-1 common layer 223-1, the 2-2 common layer 223-2, and the 2-3 common layer 223-3 may be arranged spaced (e.g., arranged apart) from each other. The 3-1 common layer 225-1, the 3-2 common layer 225-2, and the 3-3 common layer 225-3 may be arranged spaced (e.g., arranged apart) from each other, and the 4-1 common layer 227-1, the 4-2 common layer 227-2, and the 4-3 common layer 227-3 may be arranged spaced (e.g., arranged apart) from each other. Accordingly, the first intermediate layer 220-1, the second intermediate layer 220-2, and the third intermediate layer 220-3 may be arranged spaced (e.g., arranged apart) from each other. That is, the second intermediate layer 220-2 may be arranged spaced (e.g., arranged apart) from the first intermediate layer 220-1, and the third intermediate layer 220-3 may be arranged spaced (e.g., arranged apart) from the first intermediate layer 220-1 and the second intermediate layer 220-2.

As described above, the first intermediate layer 220-1 of the first organic light-emitting diode OLED1, the second intermediate layer 220-2 of the second organic light-emitting diode OLED2, and the third intermediate layer 220-3 of the third organic light-emitting diode OLED3 may include layers concurrently (e.g., simultaneously) formed of the same material through the same process. More specifically, such layers may be formed by depositing a material for forming the layers on the entire surface of the substrate and patterning the same. That is, such layers may be formed by depositing the material for forming the layers on the entire surface of the substrate and partially removing the material deposited on the substrate. For example, as described below, by applying a voltage to the heating metal layer HML during the manufacturing process of the display device 1 to generate joule heat at the heating metal layer HML, an organic material on the heating metal layer HML, e.g., a part of at least one of a plurality of common layers and a part of the charge generation layer may be removed.

When a part of the material deposited on the substrate is not removed, and the layers are formed in an integrated manner in the first organic light-emitting diode OLED1, the second organic light-emitting diode OLED2, and the third organic light-emitting diode OLED3, a leakage current may flow between the first organic light-emitting diode OLED1 and the second organic light-emitting diode OLED2 through such layers. For example, even when a current is intended to be supplied only to the first organic light-emitting diode OLED1 emitting green light, the current may also be supplied to the second organic light-emitting diode OLED2 through a layer integrated with the 1-1 common layer 221-1 of the first organic light-emitting diode OLED1, e.g., the 1-2 common layer 221-2. Alternatively, the current may also be supplied to the second organic light-emitting diode OLED2 through a layer integrated with the 2-1 common layer 223-1, e.g., the 2-2 common layer 223-2 and may also be supplied to the second organic light-emitting diode OLED2 through a layer integrated with the first charge generation layer 224-1, e.g., the second charge generation layer 224-2. Alternatively, the current may also be supplied to the second organic light-emitting diode OLED2 through a layer integrated with the 3-1 common layer 225-1, e.g., the 3-2 common layer 225-2 and may also be supplied to the second organic light-emitting diode OLED2 through a layer integrated with the 4-1 common layer 227-1, e.g., the 4-2 common layer 227-2.

As a result, not only green light may be emitted from the first organic light-emitting diode OLED1, but also red light may be emitted from the second organic light-emitting diode OLED2 which may lead to degradation of color purity and display quality. Such effect that a current is also supplied to the second organic light-emitting diode OLED2 through a layer integrated with the 1-1 common layer 221-1 of the first organic light-emitting diode OLED1 may occur in the third organic light-emitting diode OLED3 as well.

However, in the display device 1 according to the present embodiment, the first intermediate layer 220-1, the second intermediate layer 220-2, and the third intermediate layer 220-3 may be arranged spaced (e.g., arranged apart) from each other as described above. That is, even when a part of the layers included in the first intermediate layer 220-1, a part of the layers included in the second intermediate layer 220-2, and a part of the layers included in the third intermediate layer 220-3 are concurrently (e.g., simultaneously) formed of the same material through the same process, such layers may not be formed in an integrated manner in the first organic light-emitting diode OLED1, the second organic light-emitting diode OLED2, and the third organic light-emitting diode OLED3. Accordingly, a current leakage through the layers may not occur between the first organic light-emitting diode OLED1 and the second organic light-emitting diode OLED2. This effect of preventing a current leakage between the first organic light-emitting diode OLED1 and the second organic light-emitting diode OLED2 may also occur between the first organic light-emitting diode OLED1 and the third organic light-emitting diode OLED3.

The opposite electrode 230 may be disposed on the display area DA to cover the display area DA. That is, the opposite electrode 230 may be formed in an integrated manner in the first organic light-emitting diode OLED1, the second organic light-emitting diode OLED2, and the third organic light-emitting diode OLED3 and correspond to a first pixel electrode 210-1, a second pixel electrode 210-2, and a third pixel electrode 210-3. For example, the opposite electrode 230 may be arranged to overlap all of the first pixel electrode 210-1, the second pixel electrode 210-2, and the third pixel electrode 210-3. The opposite electrode 230 may be arranged to cover not only the display area DA but also the peripheral area PA (see FIG. 1B).

The opposite electrode 230 may include a transparent conductive layer formed of ITO, In₂O₃, and/or IZO, and include a semi-transmissive film including a metal such as Al, and/or Ag, etc. For example, the opposite electrode 230 may be a semi-transmissive film including Mg and/or Ag. In one or more embodiments, a capping layer may be disposed on the opposite electrode 230. For example, the capping layer may have a single-layer or multi-layer structure including a material selected from an organic material, an inorganic material, and/or a blend thereof. In an optional embodiment, a LiF layer may be disposed on the capping layer.

The heating metal layer HML may be disposed on the pixel-defining layer 215. More specifically, when seen from the direction perpendicular to the substrate 100, the heating metal layer HML may be arranged between the first opening OP1 and the second opening OP2. That is, on a plane, the heating metal layer HML may be arranged between the first opening OP1 and the second opening OP2. As described above in relation to FIG. 3, when seen from the direction perpendicular to the substrate 100, the heating metal layer HML may be around (e.g., may surround) the first opening OP1. Accordingly, when seen from the direction perpendicular to the substrate 100, the heating metal layer HML may be arranged between the first opening OP1 and the third opening OP3 as well.

The heating metal layer HML may include a metal having certain resistance. When a certain voltage is applied during the manufacturing process of the display device 1, the heating metal layer HML may generate joule heat. In other words, when a certain voltage is applied to the heating metal layer HML during the manufacturing process of the display device 1, the joule heat may be generated from the heating metal layer HML. Accordingly, as described below, an organic material on the heating metal layer HML, for example, a part of at least one of a plurality of common layers and a part of the charge generation layer may be removed. To this end, the heating metal layer HML may include a metal having certain resistance. For example, the heating metal layer HML may include Ag. However, the present disclosure is not limited thereto, and a metal included in the heating metal layer HML may be any metal having certain resistance.

The inorganic insulating layer IIL may be disposed on the heating metal layer HML. That is, the inorganic insulating layer IIL may cover the heating metal layer HML. More specifically, the inorganic insulating layer IIL may cover an upper surface (in +z direction) and a lateral surface of the heating metal layer HML. The inorganic insulating layer IIL may include an inorganic insulating material. For example, the inorganic insulating layer IIL may include at least one of a silicon oxide (SiOx), a silicon nitride (SiN_{X}), and/or a silicon oxynitride (SiO_{X}N_{Y}). However, the present disclosure is not limited thereto.

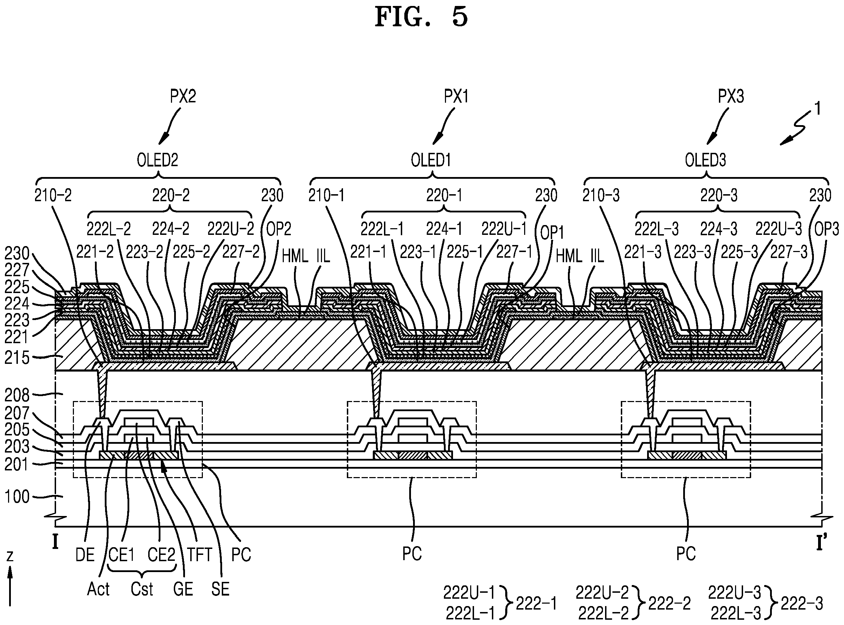

FIG. 4 illustrates that the inorganic insulating layer IIL covers the upper surface (in +z direction) and the lateral surface of the heating metal layer HML and a part of an upper surface (in +z direction) of the pixel-defining layer 215; however, the present disclosure is not limited thereto. For example, as illustrated in FIG. 5, which is a cross-sectional view schematically illustrating the display device 1 according to one or more embodiments, the inorganic insulating layer IIL may entirely cover the upper surface (in +z direction) of the pixel-defining layer 215. In addition, the inorganic insulating layer IIL may cover an inner surface of the pixel-defining layer 215 defining the first opening OP1, an inner surface of the pixel-defining layer 215 defining the second opening OP2, and an inner surface of the pixel-defining layer 215 defining the third opening OP3.

On a plane, a part of the heating metal layer HML may overlap a part of the first intermediate layer 220-1. More specifically, on a plane, a part of the heating metal layer HML may overlap a part of the first charge generation layer 224-1, a part of the 1-1 common layer 221-1, a part of the 2-1 common layer 223-1, a part of the 3-1 common layer 225-1, and a part of the 4-1 common layer 227-1. In other words, a part of the edge of the heating metal layer HML may be covered by a part of the first intermediate layer 220-1. That is, a part of the first charge generation layer 224-1, a part of the 1-1 common layer 221-1, a part of the 2-1 common layer 223-1, a part of the 3-1 common layer 225-1, and a part of the 4-1 common layer 227-1 may be disposed on the heating metal layer HML.

Similarly, on a plane, a part of the heating metal layer HML may overlap a part of the second intermediate layer 220-2. More specifically, on a plane, a part of the heating metal layer HML may overlap a part of the second charge generation layer 224-2, a part of the 1-2 common layer 221-2, a part of the 2-2 common layer 223-2, a part of the 3-2 common layer 225-2, and a part of the 4-2 common layer 227-2. That is, a part of the second charge generation layer 224-2, a part of the 1-2 common layer 221-2, a part of the 2-2 common layer 223-2, a part of the 3-2 common layer 225-2, and a part of the 4-2 common layer 227-2 may be disposed on the heating metal layer HML. On a plane, a part of the heating metal layer HML may overlap a part of the third intermediate layer 220-3. More specifically, on a plane, a part of the heating metal layer HML may overlap a part of the third charge generation layer 224-3, a part of the 1-3 common layer 221-3, a part of the 2-3 common layer 223-3, a part of the 3-3 common layer 225-3, and a part of the 4-3 common layer 227-3. That is, a part of the third charge generation layer 224-3, a part of the 1-3 common layer 221-3, a part of the 2-3 common layer 223-3, a part of the 3-3 common layer 225-3, and a part of the 4-3 common layer 227-3 may be disposed on the heating metal layer HML.

As described above, as the inorganic insulating layer IIL covers the heating metal layer HML, the heating metal layer HML may not be in direct contact with an organic material on the heating metal layer HML, for example, a part of at least one of the plurality of common layers and a part of the charge generation layer. That is, the heating metal layer HML may not be electrically connected to an organic material on the heating metal layer HML, for example, a part of at least one of the plurality of common layers and a part of the charge generation layer.

In other words, a part of the inorganic insulating layer IIL may be interposed between a part of the first intermediate layer 220-1 and a part of the heating metal layer HML which overlap each other. For example, a part of the inorganic insulating layer IIL may be interposed between a part of the first charge generation layer 224-1 and a part of the heating metal layer HML which overlap each other. More specifically, a part of the inorganic insulating layer IIL may be interposed between a part of the 1-1 common layer 221-1 and a part of the heating metal layer HML which overlap each other. Accordingly, a part of the first intermediate layer 220-1 overlapping a part of the heating metal layer HML may not be in direct contact with a part of the heating metal layer HML. That is, a part of the first intermediate layer 220-1 overlapping a part of the heating metal layer HML may not be electrically connected to a part of the heating metal layer HML.

Similarly, a part of the inorganic insulating layer IIL may be interposed between a part of the second charge generation layer 224-2 and a part of the heating metal layer HML which overlap each other. More specifically, a part of the inorganic insulating layer IIL may be interposed between a part of the 1-2 common layer 221-2 and a part of the heating metal layer HML which overlap each other. A part of the inorganic insulating layer IIL may be interposed between a part of the third charge generation layer 224-3 and a part of the heating metal layer HML which overlap each other. More specifically, a part of the inorganic insulating layer IIL may be interposed between a part of the 1-3 common layer 221-3 and a part of the heating metal layer HML which overlap each other. That is, a part of the second intermediate layer 220-2 overlapping a part of the heating metal layer HML may not be electrically connected to a part of the heating metal layer HML, and a part of the third intermediate layer 220-3 overlapping a part of the heating metal layer HML may not be electrically connected to a part of the heating metal layer HML.

In general, on a plane, when a part of the heating metal layer HML overlaps a part of intermediate layers, the intermediate layers may be electrically connected through the heating metal layer HML. That is, even though the intermediate layers are arranged spaced (e.g., arranged apart) from each other, when the intermediate layers are in direct contact with the heating metal layer HML, the intermediate layers may be electrically connected through the heating metal layer HML, and accordingly, a leakage current may flow between the organic light-emitting diodes OLED.

However, in the display device 1 according to the present embodiment, the inorganic insulating layer IIL may cover the heating metal layer HML as described above. That is, a part of the inorganic insulating layer IIL may be interposed between a part of the first intermediate layer 220-1 and a part of the heating metal layer HML which overlap each other. A part of the inorganic insulating layer IIL may be interposed between a part of the second intermediate layer 220-2 and a part of the heating metal layer HML which overlap each other. Accordingly, a part of the first intermediate layer 220-1 overlapping a part of the heating metal layer HML may not be electrically connected to a part of the heating metal layer HML. A part of the second intermediate layer 220-2 overlapping a part of the heating metal layer HML may not be electrically connected to a part of the heating metal layer HML, and accordingly, a leakage current may not flow between the first organic light-emitting diode OLED1 and the second organic light-emitting diode OLED2. A part of the inorganic insulating layer IIL may be interposed between a part of the third intermediate layer 220-3 and a part of the heating metal layer HML which overlap each other. A part of the third intermediate layer 220-3 overlapping a part of the heating metal layer HML may not be electrically connected to a part of the heating metal layer HML. Accordingly, a leakage current may not flow between the first organic light-emitting diode OLED1 and the third organic light-emitting diode OLED3.

FIG. 4 illustrates that all of the layers included in the first intermediate layer 220-1 are arranged spaced (e.g., arranged apart) from the layers included in the second intermediate layer 220-2; however, the present disclosure is not limited thereto. For example, a part of the layers included in the first intermediate layer 220-1 may not be arranged spaced (e.g., arranged apart) from a part of the layers included in the second intermediate layer 220-2. That is, a part of the layers included in the first intermediate layer 220-1 may be in contact with a part of the layers included in the second intermediate layer 220-2. In addition, a part of the layers included in the first intermediate layer 220-1 may be in contact with the layers included in the third intermediate layer 220-3.

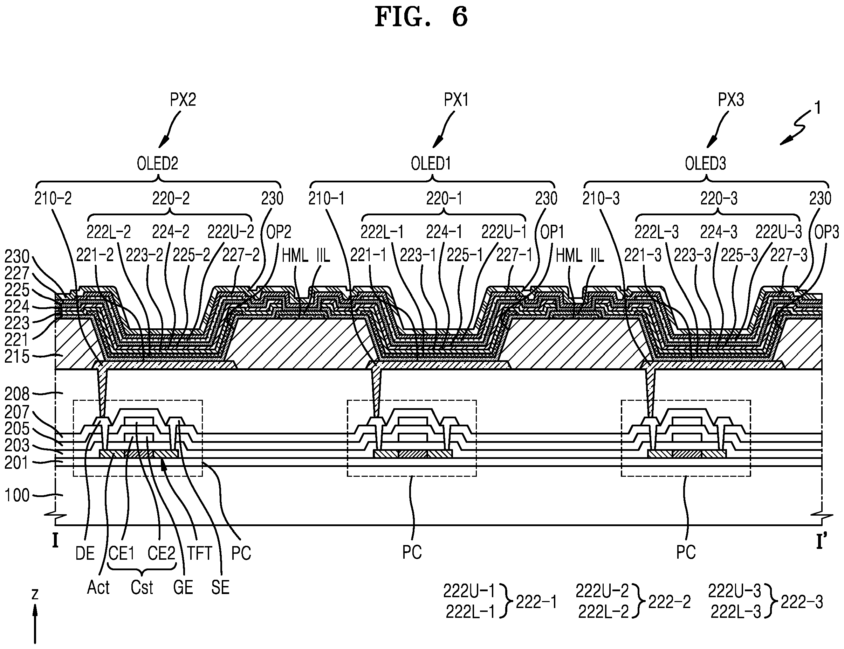

FIG. 6 is a cross-sectional view schematically illustrating a display device 1 according to one or more embodiments. As illustrated in FIG. 6, the sub-common layers disposed on the charge generation layer 224 may be in contact with each other. More specifically, the 3-1 common layer 225-1 may be in contact with the 3-2 common layer 225-2, and the 4-1 common layer 227-1 may be in contact with the 4-2 common layer 227-2. The 3-1 common layer 225-1 may be in contact with the 3-3 common layer 225-3, and the 4-1 common layer 227-1 may be in contact with the 4-3 common layer 227-3. Even in this case, the first charge generation layer 224-1, the second charge generation layer 224-2, and the third charge generation layer 224-3 may be arranged spaced (e.g., arranged apart) from each other. The 1-1 common layer 221-1, the 1-2 common layer 221-2, and the 1-3 common layer 221-3 may be arranged spaced (e.g., arranged apart) from each other, and the 2-1 common layer 223-1, the 2-2 common layer 223-2, and the 2-3 common layer 223-3 may be arranged spaced (e.g., arranged apart) from each other.

To substantially implement the effect of preventing a leakage current, disconnection between sub-charge generation layers may act as a major factor. Accordingly, by arranging the first charge generation layer 224-1 spaced from the second charge generation layer 224-2, a leakage current may not flow between the first organic light-emitting diode OLED1 and the second organic light-emitting diode OLED2. Of course, by arranging the first charge generation layer 224-1 spaced from the third charge generation layer 224-3, a leakage current may not flow between the first organic light-emitting diode OLED1 and the third organic light-emitting diode OLED3.

Although the display device 1 has been described mainly, the present disclosure is not limited thereto. For example, a method of manufacturing the display device 1 may fall within the scope of the present disclosure.

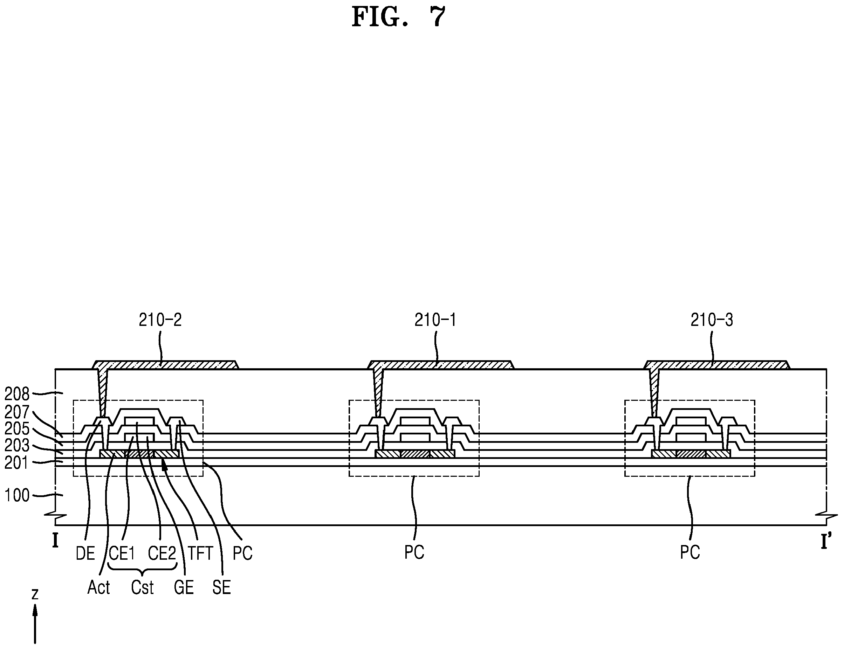

FIGS. 7 to 13 are cross-sectional views for describing a method of manufacturing a display device, according to one or more embodiments. That is, FIGS. 7 to 13 are cross-sectional view schematically illustrating a part of the manufacturing process of the display device 1 of FIG. 4. More specifically, FIGS. 7 to 13 are cross-sectional views schematically illustrating the process of forming the first organic light-emitting diode OLED1, the second organic light-emitting diode OLED2, and the third organic light-emitting diode OLED3 included in the display device 1 of FIG. 4. Hereinafter, the embodiments will be described from the perspective of manufacturing process, and as for a material forming each layer, a specific structure, etc., the descriptions made in relation to FIG. 4 are cited unless otherwise mentioned.

First, as illustrated in FIG. 7, the first pixel electrode 210-1, the second pixel electrode 210-2, and the third pixel electrode 210-3 may be formed on the substrate 100. The first pixel electrode 210-1, the second pixel electrode 210-2, and the third pixel electrode 210-3 may be arranged spaced (e.g., arranged apart) from each other.

The pixel circuit PC may be formed on the substrate 100. More specifically, before forming the first pixel electrode 210-1, the second pixel electrode 210-2, and the third pixel electrode 210-3 on the substrate 100, the buffer layer 201 may be formed on the substrate 100, the semiconductor layer Act may be formed on the buffer layer 201, the gate insulating layer 203 may be formed on the semiconductor layer Act, and the gate electrode GE may be formed on the gate insulating layer 203. The gate electrode GE may be the first capacitor electrode CE1 of the storage capacitor Cst. The first interlayer insulating layer 205 may be formed on the gate electrode GE, and the second capacitor electrode CE2 may be formed on the first interlayer insulating layer 205. The second interlayer insulating layer 207 may be formed on the second capacitor electrode CE2. The source electrode SE and the drain electrode DE may be formed on the second interlayer insulating layer 207, and the planarization layer 208 may be formed on the source electrode SE and the drain electrode DE. Such formation of the pixel circuit PC may be performed through a publicly known photo process, etc., and thus detailed description thereon is omitted.

The first pixel electrode 210-1, the second pixel electrode 210-2, and the third pixel electrode 210-3 may be formed on the planarization layer 208. More specifically, after forming a contact hole in the planarization layer 208 such that each of the first pixel electrode 210-1, the second pixel electrode 210-2, and the third pixel electrode 210-3 is in contact with any one of the source electrode SE and the drain electrode DE, a preliminary pixel electrode layer may be formed on the planarization layer 208 in correspondence with the entire surface of the substrate 100. By patterning the preliminary pixel electrode layer, the first pixel electrode 210-1, the second pixel electrode 210-2, and the third pixel electrode 210-3 may be formed. That is, the first pixel electrode 210-1, the second pixel electrode 210-2, and the third pixel electrode 210-3 may be formed on the substrate 100.

The preliminary pixel electrode layer, the first pixel electrode 210-1, the second pixel electrode 210-2, and the third pixel electrode 210-3 may include a transparent conductive layer formed of a transparent conductive oxide such as ITO, In₂O₃, and/or IZO, etc. and a reflective layer formed of a metal such as Al, and/or Ag, etc. For example, the first pixel electrode 210-1, the second pixel electrode 210-2, and the third pixel electrode 210-3 may have a triple-layer structure of ITO/Ag/ITO.

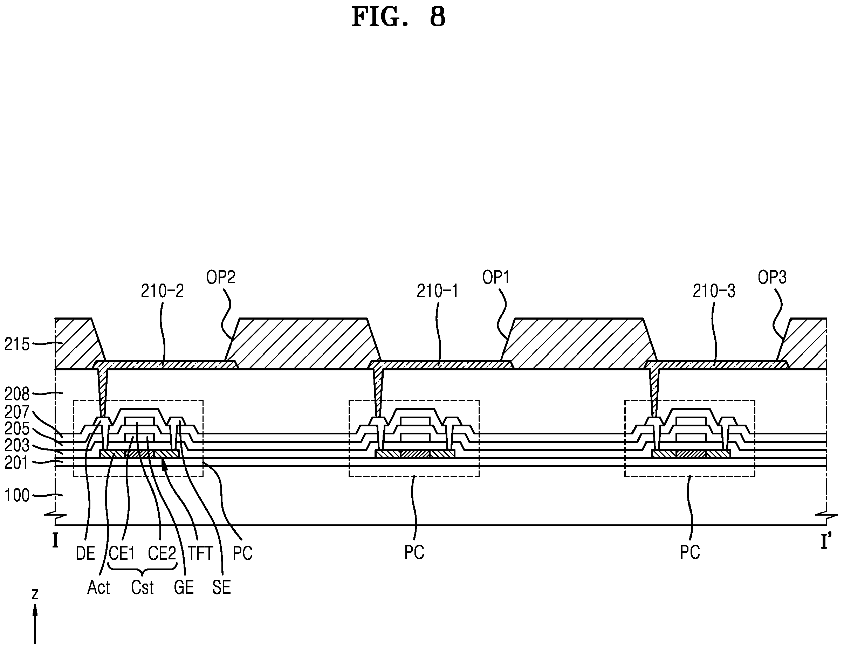

As illustrated in FIG. 8 the pixel-defining layer 215 may be formed on the substrate 100. More specifically, the pixel-defining layer 215 may be formed on the first pixel electrode 210-1, the second pixel electrode 210-2, the third pixel electrode 210-3, and the planarization layer 208. The pixel-defining layer 215 may include the first opening OP1, the second opening OP2, and the third opening OP3. In other words, the pixel-defining layer 215 may include an inner surface defining the first opening OP1, an inner surface defining the second opening OP2, and an inner surface defining the third opening OP3. The first opening OP1 may expose a central portion of the first pixel electrode 210-1, the second opening OP2 may expose a central portion of the second pixel electrode 210-2, and the third opening OP3 may expose a central portion of the third pixel electrode 210-3.

More specifically, a preliminary pixel-defining layer may be formed to cover the first pixel electrode 210-1, the second pixel electrode 210-2, the third pixel electrode 210-3, and the planarization layer 208. By patterning the preliminary pixel-defining layer, the pixel-defining layer 215 may be formed. In other words, by partially removing the preliminary pixel-defining layer, the pixel-defining layer 215 may be formed. That is, the pixel-defining layer 215 may be formed on the substrate 100. The preliminary pixel-defining layer and the pixel-defining layer 215 may include an organic material such as polyimide, and/or hexamethyldisiloxane (HMDSO), etc.

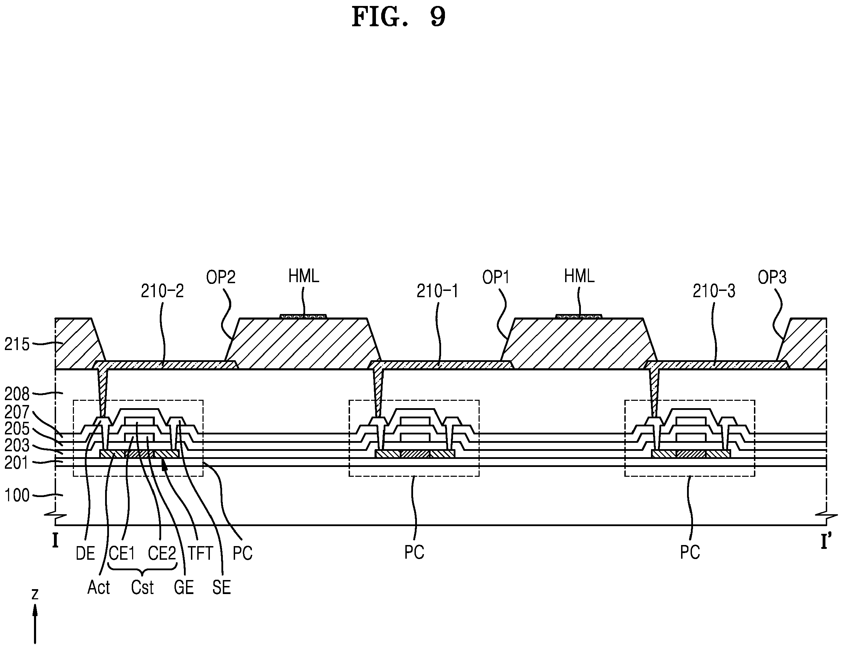

As illustrated in FIG. 9, the heating metal layer HML may be formed on the pixel-defining layer 215. More specifically, when seen from the direction perpendicular to the substrate 100 (e.g., z direction or -z direction), the heating metal layer HML may be formed on the pixel-defining layer 215 between the first opening OP1 and the second opening OP2. When seen from the direction perpendicular to the substrate 100 (e.g., z direction or -z direction), the heating metal layer HML may be formed on the pixel-defining layer 215 to be around (e.g., to surround) each of the openings included in the pixel-defining layer 215, for example, the first opening OP1, the second opening OP2, and the third opening OP3. Accordingly, when seen from the direction perpendicular to the substrate 100, the heating metal layer HML may be arranged between the first opening OP1 and the third opening OP3 as well.

More specifically, a preliminary heating metal layer may be formed to cover the pixel-defining layer 215, the first pixel electrode 210-1, the second pixel electrode 210-2, and the third pixel electrode 210-3. By patterning the preliminary heating metal layer, the heating metal layer HML may be formed. The preliminary heating metal layer and the heating metal layer HML may include Ag.

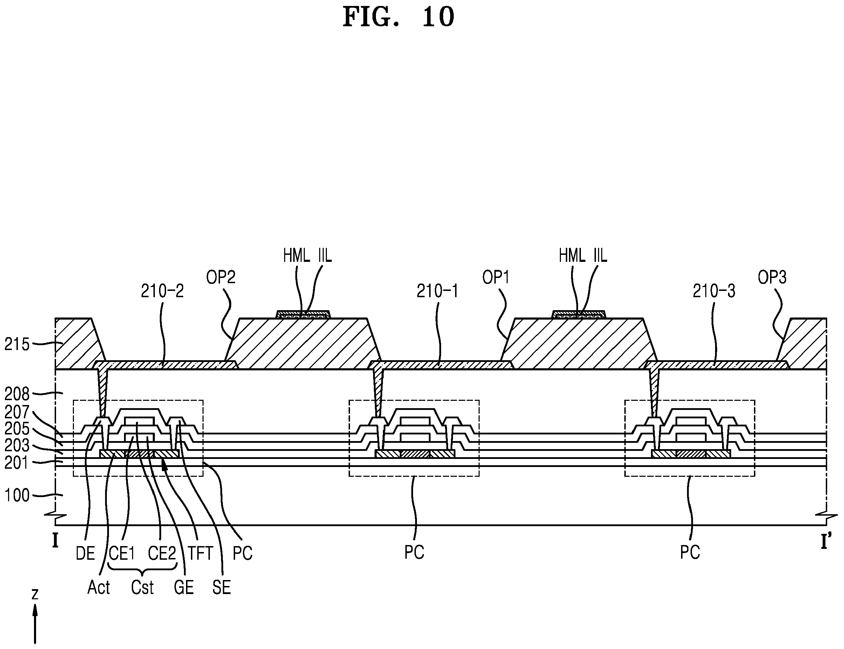

As illustrated in FIG. 10, the inorganic insulating layer IIL may be formed on the pixel-defining layer 215 such that the inorganic insulating layer IIL covers the heating metal layer HML. More specifically, the inorganic insulating layer IIL may be formed on the pixel-defining layer 215 such that the inorganic insulating layer IIL covers an upper surface and a lateral surface of the heating metal layer HML. For example, a preliminary inorganic insulating layer may be formed to cover the pixel-defining layer 215, the first pixel electrode 210-1, the second pixel electrode 210-2, the third pixel electrode 210-3, and the heating metal layer HML. By patterning the preliminary inorganic insulating layer, the inorganic insulating layer IIL may be formed. The preliminary inorganic insulating layer and/or the inorganic insulating layer IIL may include at least one of a silicon oxide (SiOx), a silicon nitride (SiNx), and/or a silicon oxynitride (SiO_{X}N_{Y}).

In one or more embodiments, the inorganic insulating layer IIL may be formed on the pixel-defining layer 215 such that the inorganic insulating layer IIL covers the entire upper surface of the pixel-defining layer 215 (in +z direction). In one or more embodiments, the inorganic insulating layer IIL may be formed on the pixel-defining layer 215 such that the inorganic insulating layer IIL covers the entire upper surface of the pixel-defining layer 215 (in +z direction), the inner surface of the pixel-defining layer 215 defining the first opening OP1, the inner surface of the pixel-defining layer 215 defining the second opening OP2, and the inner surface of the pixel-defining layer 215 defining the third opening OP3.

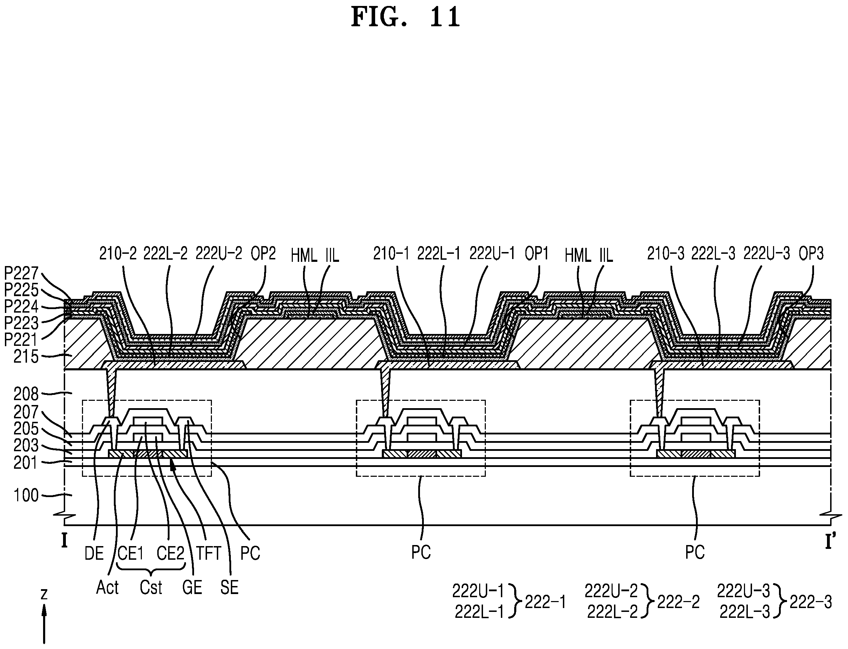

As illustrated in FIG. 11, a first preliminary common layer P221, the first lower emission layer 222L-1, the second lower emission layer 222L-2, the third lower emission layer 222L-3, a second preliminary common layer P223, a preliminary charge generation layer P224, a third preliminary common layer P225, the first upper emission layer 222U-1, the second upper emission layer 222U-2, the third upper emission layer 222U-3, and a fourth preliminary common layer P227 may be sequentially stacked on the first pixel electrode 210-1, the second pixel electrode 210-2, and the third pixel electrode 210-3.

More specifically, the first preliminary common layer P221 may be formed over the first pixel electrode 210-1, the second pixel electrode 210-2, and the third pixel electrode 210-3. The first lower emission layer 222L-1, the second lower emission layer 222L-2, and the third lower emission layer 222L-3 may be formed on the first preliminary common layer P221 such that the first lower emission layer 222L-1, the second lower emission layer 222L-2, and the third lower emission layer 222L-3 respectively overlap the first pixel electrode 210-1, the second pixel electrode 210-2, and the third pixel electrode 210-3. The second preliminary common layer P223 may be formed over the first lower emission layer 222L-1, the second lower emission layer 222L-2, and the third lower emission layer 222L-3. The preliminary charge generation layer P224 may be formed on the second preliminary common layer P223. The third preliminary common layer P225 may be formed on the preliminary charge generation layer P224. The first upper emission layer 222U-1, the second upper emission layer 222U-2, and the third upper emission layer 222U-3 may be formed on the third preliminary common layer P225 such that the first upper emission layer 222U-1, the second upper emission layer 222U-2, and the third upper emission layer 222U-3 respectively overlap the first lower emission layer 222L-1, the second lower emission layer 222L-2, and the third lower emission layer 222L-3. The fourth preliminary common layer P227 may be formed over the first upper emission layer 222U-1, the second upper emission layer 222U-2, and the third upper emission layer 222U-3.

The first preliminary common layer P221, the second preliminary common layer P223, the preliminary charge generation layer P224, the third preliminary common layer P225, and the fourth preliminary common layer P227 may be deposited commonly to correspond to the entire surface of the display area DA by using an open mask. The first lower emission layer 222L-1, the second lower emission layer 222L-2, and the third lower emission layer 222L-3 as well as the first upper emission layer 222U-1, the second upper emission layer 222U-2, and the third upper emission layer 222U-3 may be formed through patterning per pixel. The first lower emission layer 222L-1, the second lower emission layer 222L-2, the third lower emission layer 222L-3, the first upper emission layer 222U-1, the second upper emission layer 222U-2, and the third upper emission layer 222U-3 may be formed by using a fine metal mask (FMM), an inkjet method, etc.

The first preliminary common layer P221 may have a single-layer structure or a multi-layer structure. For example, when the first preliminary common layer P221 is formed of a high-molecular weight material, the first preliminary common layer P221 may include a hole transport layer (HTL). When the first preliminary common layer P221 is formed of a low-molecular weight material, the first preliminary common layer P221 may include a hole injection layer (HIL) and a hole transport layer (HTL). The second preliminary common layer P223 may include an electron transport layer (ETL), and the preliminary charge generation layer P224 may include the n-type charge generation layer n-CGL and the p-type charge generation layer p-CGL. The third preliminary common layer P225 may include a hole transport layer (HTL), and the fourth preliminary common layer P227 may include an electron transport layer (ETL). In one or more embodiments, the fourth preliminary common layer P227 may further include an electron injection layer (EIL). The description regarding the hole injection layer (HIL), the hole transport layer (HTL), the electron transport layer (ETL), the electron injection layer (EIL), the n-type charge generation layer n-CGL, and the p-type charge generation layer p-CGL made in relation to FIG. 4 may be applied to the hole injection layer (HIL), the hole transport layer (HTL), the electron transport layer (ETL), the electron injection layer (EIL), the n-type charge generation layer n-CGL, and the p-type charge generation layer p-CGL of FIG. 11 as well, and thus, any redundant description is omitted.

The first lower emission layer 222L-1 and the first upper emission layer 222U-1 may be formed by using, for example, a green dopant to a certain host material. The second lower emission layer 222L-2 and the second upper emission layer 222U-2 may be formed by using, for example, a red dopant to a certain host material, and the third lower emission layer 222L-3 and the third upper emission layer 222U-3 may be formed by using, for example, a blue dopant to a certain host material.

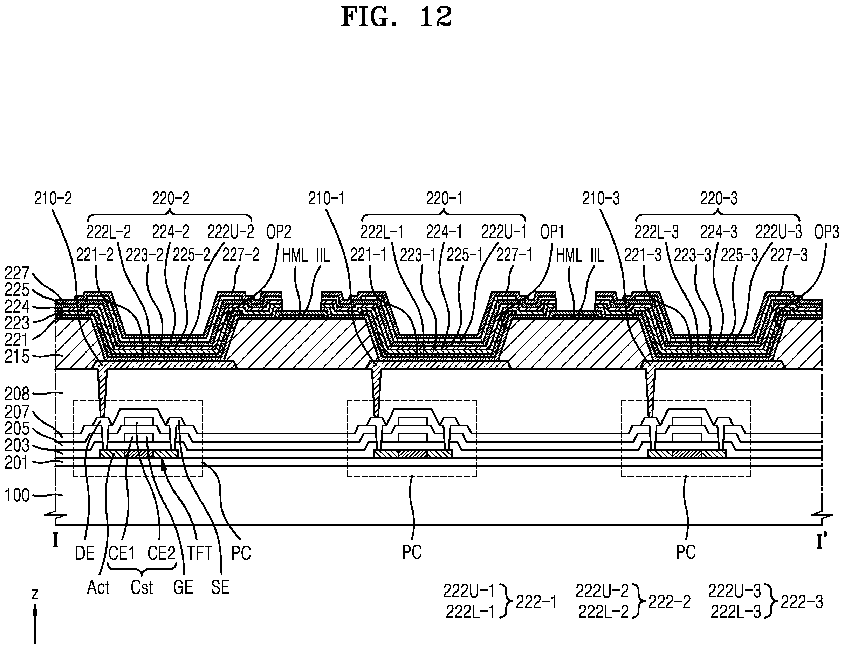

As illustrated in FIG. 12, a part of the first preliminary common layer P221, a part of the second preliminary common layer P223, a part of the preliminary charge generation layer P224, a part of the third preliminary common layer P225, and a part of the fourth preliminary common layer P227 each overlapping the heating metal layer HML may be removed. More specifically, a part of the first preliminary common layer P221, a part of the second preliminary common layer P223, a part of the preliminary charge generation layer P224, a part of the third preliminary common layer P225, and a part of the fourth preliminary common layer P227 each overlapping the central portion of the heating metal layer HML may be removed.

In one or more embodiments, the heating metal layer HML may be electrically connected to a power source. A voltage may be applied to the heating metal layer HML through the power source. When a voltage is applied to the heating metal layer HML, due to certain resistance of the heating metal layer HML, the heating metal layer HML may generate joule heat. In other words, when a voltage is applied to the heating metal layer HML, due to certain resistance of the heating metal layer HML, the joule heat may be generated from the heating metal layer HML. The joule heat generated from the heating metal layer HML may remove a part of the first preliminary common layer P221, a part of the second preliminary common layer P223, a part of the preliminary charge generation layer P224, a part of the third preliminary common layer P225, and a part of the fourth preliminary common layer P227 each overlapping the heating metal layer HML.

In general, organic materials (e.g., materials included in each of the first preliminary common layer P221, the second preliminary common layer P223, the preliminary charge generation layer P224, the third preliminary common layer P225, and the fourth preliminary common layer P227) may be removed by heating them at a temperature higher than 400 °C. Accordingly, a part of the first preliminary common layer P221, a part of the second preliminary common layer P223, a part of the preliminary charge generation layer P224, a part of the third preliminary common layer P225, and a part of the fourth preliminary common layer P227 may be heated by the joule heat generated due to the applied voltage and removed. The power source may have various types. That is, a voltage may be applied to the heating metal layer HML, and various types of power source capable of controlling the level and application time of the voltage applied to the heating metal layer HML may be used.

Through this, the 1-1 common layer 221-1, the 1-2 common layer 221-2, the 2-1 common layer 223-1, the 2-2 common layer 223-2, the first charge generation layer 224-1, the second charge generation layer 224-2, the 3-1 common layer 225-1, the 3-2 common layer 225-2, the 4-1 common layer 227-1, and the 4-2 common layer 227-2 as illustrated in FIG. 12 may be formed. During the process, the 1-3 common layer 221-3, the 2-3 common layer 223-3, the third charge generation layer 224-3, the 3-3 common layer 225-3, and the 4-3 common layer 227-3 may be formed as well.

That is, the first common layer 221 may be the patterned first preliminary common layer P221, and the 1-1 common layer 221-1, the 1-2 common layer 221-2, and the 1-3 common layer 221-3 may be parts of the first common layer 221. The second common layer 223 may be the patterned second preliminary common layer P223, and the 2-1 common layer 223-1, the 2-2 common layer 223-2, and the 2-3 common layer 223-3 may be parts of the second common layer 223. The charge generation layer 224 may be the patterned preliminary charge generation layer P224, and the first charge generation layer 224-1, the second charge generation layer 224-2, and the third charge generation layer 224-3 may be parts of the charge generation layer 224. The third common layer 225 may be the patterned third preliminary common layer P225, and the 3-1 common layer 225-1, the 3-2 common layer 225-2, and the 3-3 common layer 225-3 may be parts of the third common layer 225. The fourth common layer 227 may be the patterned fourth preliminary common layer P227, and the 4-1 common layer 227-1, the 4-2 common layer 227-2, and the 4-3 common layer 227-3 may be parts of the fourth common layer 227.

On a plane, a part of the heating metal layer HML may overlap a part of the 1-1 common layer 221-1, a part of the 2-1 common layer 223-1, a part of the first charge generation layer 224-1, a part of the 3-1 common layer 225-1, and a part of the 4-1 common layer 227-1. That is, a part of the 1-1 common layer 221-1, a part of the 2-1 common layer 223-1, a part of the first charge generation layer 224-1, a part of the 3-1 common layer 225-1, and a part of the 4-1 common layer 227-1 may be disposed on the heating metal layer HML.

Similarly, on a plane, a part of the heating metal layer HML may overlap a part of the 1-2 common layer 221-2, a part of the 2-2 common layer 223-2, a part of the second charge generation layer 224-2, a part of the 3-2 common layer 225-2, and a part of the 4-2 common layer 227-2. That is, a part of the 1-2 common layer 221-2, a part of the 2-2 common layer 223-2, a part of the second charge generation layer 224-2, a part of the 3-2 common layer 225-2, and a part of the 4-2 common layer 227-2 may be disposed on the heating metal layer HML. On a plane, a part of the heating metal layer HML may overlap a part of the 1-3 common layer 221-3, a part of the 2-3 common layer 223-3, a part of the third charge generation layer 224-3, a part of the 3-3 common layer 225-3, and a part of the 4-3 common layer 227-3. A part of the 1-3 common layer 221-3, a part of the 2-3 common layer 223-3, a part of the third charge generation layer 224-3, a part of the 3-3 common layer 225-3, and a part of the 4-3 common layer 227-3 may be disposed on the heating metal layer HML.

In general, when the sub-common layers and the sub-charge generation layers are disconnected by using the joule heat of the heating metal layer HML to implement the effect of preventing a leakage current, the disconnected sub-common layers and the sub-charge generation layers are not in contact with the heating metal layer HML. This is to prevent a leakage current from flowing through the heating metal layer HML in contact with the disconnected sub-common layers and the sub-charge generation layers. To this end, not only a part of the preliminary common layers on the heating metal layer HML and a part of the preliminary charge generation layer but also a part of the preliminary common layers and a part of the preliminary charge generation layer that are arranged spaced (e.g., arranged apart) from the heating metal layer HML may also be removed.

When the joule heat is generated from the heating metal layer HML by applying a voltage to the heating metal layer HML, the temperature of the heating metal layer HML may vary according to a position. For example, on a plane, as for a part of the heating metal layer HML arranged between the first pixel electrode 210-1 and the second pixel electrode 210-2, the temperature of the heating metal layer HML may be the highest at the central portion of the heating metal layer HML (e.g., a part of the heating metal layer HML in which a distance to the first pixel electrode 210-1 is identical to a distance to the second pixel electrode 210-2), and the temperature of the heating metal layer HML may decrease towards the first pixel electrode 210-1 or the second pixel electrode 210-2 from the central portion of the heating metal layer HML.

In this case, to remove a part of the preliminary common layers and a part of the preliminary charge generation layers that are adjacent to an edge of the heating metal layer HML (e.g., a part of the heating metal layer HML adjacent to the first pixel electrode 210-1 or the second pixel electrode 210-2), the voltage applied to the heating metal layer HML and the temperature of the heating metal layer HML may increase. More specifically, the temperature of the central portion of the heating metal layer HML may need to be about 500 °C or higher to raise the temperature of the edge of the heating metal layer HML to 400 °C or higher. To raise the temperature of the central portion of the heating metal layer HML to over 500 °C, a voltage higher than the voltage required for the central portion of the heating metal layer HML to reach 400 °C may need to be applied to the heating metal layer HML.

However, in the method of manufacturing a display device according to the present embodiment, the inorganic insulating layer IIL may cover the heating metal layer HML. Accordingly, even when the disconnected sub-common layers and the sub-charge generation layers overlap the heating metal layer HML, the heating metal layer HML may not be electrically connected to the sub-common layers and the sub-charge generation layers on the heating metal layer HML. Thus, as a part of the preliminary common layers and a part of the preliminary charge generation layer that are spaced from the heating metal layer HML do not need to be removed, a voltage applied to the heating metal layer HML and the temperature of the heating metal layer HML may decrease. More specifically, the temperature of the central portion of the heating metal layer HML may be 400 °C. A voltage to allow the temperature of the central portion of the heating metal layer HML to be 400 °C may be applied to the heating metal layer HML. This may reduce damages on components adjacent to the heating metal layer HML and possibility of occurrence of defects during the manufacturing process.

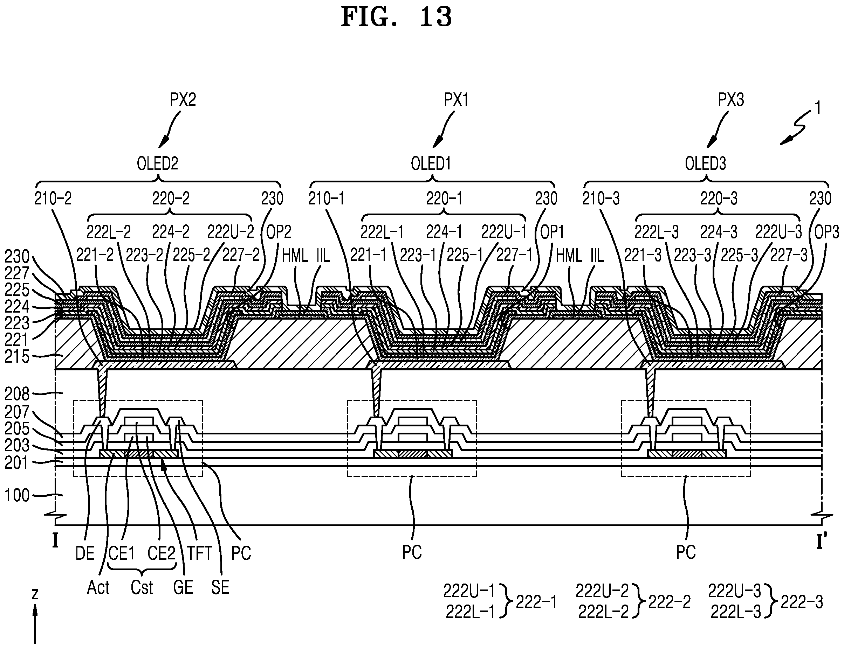

As illustrated in FIG. 13, the opposite electrode 230 may be formed over the upper surfaces of the first pixel electrode 210-1, the second pixel electrode 210-2, and the third pixel electrode 210-3. More specifically, the opposite electrode 230 may be formed in an integrated manner to correspond to the first pixel electrode 210-1, the second pixel electrode 210-2, and the third pixel electrode 210-3. Accordingly, the opposite electrode 230 may overlap all of the first pixel electrode 210-1, the second pixel electrode 210-2, and the third pixel electrode 210-3. The opposite electrode 230 may include a transparent conductive layer formed of ITO, In₂O₃, and/or IZO, and include a semi-transmissive film including a metal such as Al, and/Ag, etc. For example, the opposite electrode 230 may be a semi-transmissive film including Mg or Ag.

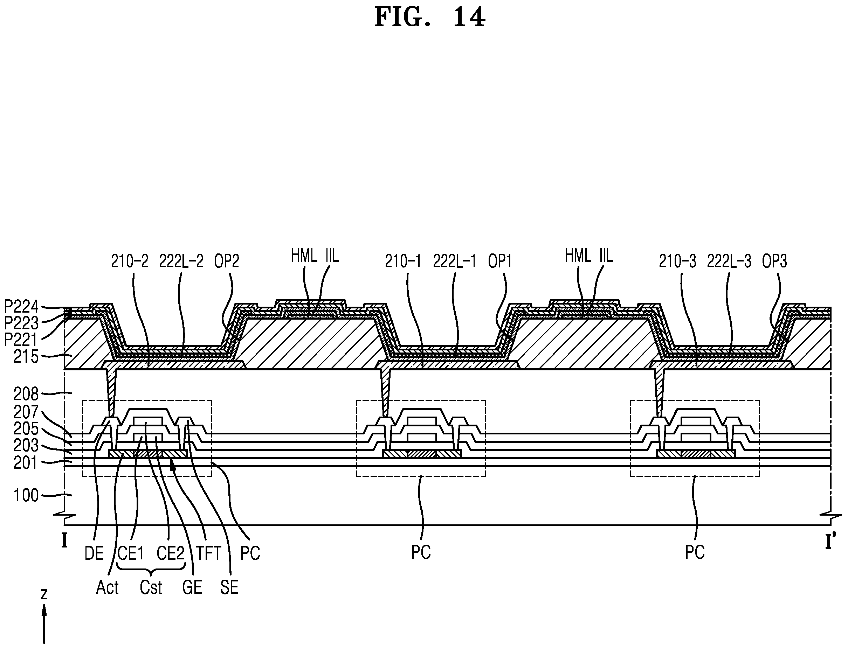

FIGS. 14 to 17 are cross-sectional views for describing a method of manufacturing a display device, according to one or more embodiments. That is, FIGS. 14 to 17 are cross-sectional view schematically illustrating a part of the manufacturing process of the display device 1 of FIG. 6. More specifically, FIGS. 14 to 17 are cross-sectional views schematically illustrating the process of forming the first organic light-emitting diode OLED1, the second organic light-emitting diode OLED2, and the third organic light-emitting diode OLED3 included in the display device 1 of FIG. 6. As a method of manufacturing a display device according to the present embodiment is merely an embodiment of the method of manufacturing a display device described above in relation to FIGS. 7 to 13 with slight modifications, embodiments are described focusing on differences with the method of manufacturing a display device described above in relation to FIGS. 7 to 13. Reference numerals in FIGS. 14 to 17 that are the same as the reference numerals in FIGS. 7 to 13 denote the same elements, and thus repeated descriptions thereof are omitted.

In the method of manufacturing a display device according to the present embodiment, the first pixel electrode 210-1, the second pixel electrode 210-2, and the third pixel electrode 210-3 may be formed on the substrate 100, the pixel-defining layer 215 may be formed on the substrate 100, the heating metal layer HML may be formed on the pixel-defining layer 215, and the inorganic insulating layer IIL may be disposed on the pixel-defining layer 215 such that the inorganic insulating layer IIL covers the heating metal layer HML. As such process are the same as the method of manufacturing a display device described above in relation to FIGS. 7 to 10, any redundant descriptions thereon are omitted.

However, in the method of manufacturing a display device according to the present embodiment, as illustrated in FIG. 14, the first preliminary common layer P221, the first lower emission layer 222L-1, the second lower emission layer 222L-2, the third lower emission layer 222L-3, the second preliminary common layer P223, and the preliminary charge generation layer P224 may be sequentially stacked on the first pixel electrode 210-1, the second pixel electrode 210-2, and the third pixel electrode 210-3.

More specifically, the first preliminary common layer P221 may be formed over the first pixel electrode 210-1, the second pixel electrode 210-2, and the third pixel electrode 210-3. The first lower emission layer 222L-1, the second lower emission layer 222L-2, and the third lower emission layer 222L-3 may be formed on the first preliminary common layer P221 such that the first lower emission layer 222L-1, the second lower emission layer 222L-2, and the third lower emission layer 222L-3 respectively overlap the first pixel electrode 210-1, the second pixel electrode 210-2, and the third pixel electrode 210-3. The second preliminary common layer P223 may be formed over the first lower emission layer 222L-1, the second lower emission layer 222L-2, and the third lower emission layer 222L-3. The preliminary charge generation layer P224 may be formed on the second preliminary common layer P223.

As the method of forming the first preliminary common layer P221, the second preliminary common layer P223, the preliminary charge generation layer P224, the first lower emission layer 222L-1, the second lower emission layer 222L-2, and the third lower emission layer 222L-3 and the material forming the same may be the same as the method of forming the first preliminary common layer P221, the second preliminary common layer P223, the preliminary charge generation layer P224, the first lower emission layer 222L-1, the second lower emission layer 222L-2, and the third lower emission layer 222L-3 and the material forming the same described above in relation to FIG. 11, any redundant descriptions thereon are omitted.

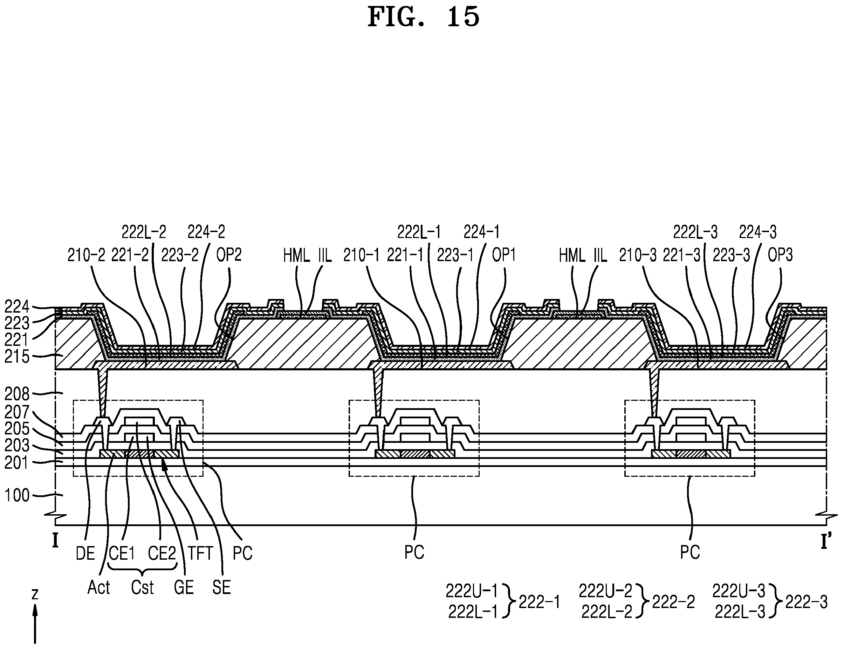

As illustrated in FIG. 15, a part of the first preliminary common layer P221, a part of the second preliminary common layer P223, and a part of the preliminary charge generation layer P224 each overlapping the heating metal layer HML may be removed. More specifically, a part of the first preliminary common layer P221, a part of the second preliminary common layer P223, and a part of the preliminary charge generation layer P224 each overlapping the central portion of the heating metal layer HML may be removed.

The heating metal layer HML may be electrically connected to the power source, and a voltage may be applied to the heating metal layer HML through the power source. When a voltage is applied to the heating metal layer HML, due to certain resistance of the heating metal layer HML, the heating metal layer HML may generate joule heat. The joule heat generated from the heating metal layer HML may remove a part of the first preliminary common layer P221, a part of the second preliminary common layer P223, and a part of the preliminary charge generation layer P224 each overlapping the heating metal layer HML.

Through this, the 1-1 common layer 221-1, the 1-2 common layer 221-2, the 2-1 common layer 223-1, the 2-2 common layer 223-2, the first charge generation layer 224-1, and the second charge generation layer 224-2 as illustrated in FIG. 15 may be formed. In the process, the 1-3 common layer 221-3, the 2-3 common layer 223-3, and the third charge generation layer 224-3 may also be formed. That is, the first common layer 221 may be the patterned first preliminary common layer P221, and the 1-1 common layer 221-1, the 1-2 common layer 221-2, and the 1-3 common layer 221-3 may be parts of the first common layer 221. The second common layer 223 may be the patterned second preliminary common layer P223, and the 2-1 common layer 223-1, the 2-2 common layer 223-2, and the 2-3 common layer 223-3 may be parts of the second common layer 223. The charge generation layer 224 may be the patterned preliminary charge generation layer P224, and the first charge generation layer 224-1, the second charge generation layer 224-2, and the third charge generation layer 224-3 may be parts of the charge generation layer 224.

On a plane, a part of the heating metal layer HML may overlap a part of the 1-1 common layer 221-1, a part of the 2-1 common layer 223-1, and a part of the first charge generation layer 224-1. That is, a part of the 1-1 common layer 221-1, a part of the 2-1 common layer 223-1, and a part of the first charge generation layer 224-1 may be disposed on the heating metal layer HML. Similarly, on a plane, a part of the heating metal layer HML may overlap a part of the 1-2 common layer 221-2, a part of the 2-2 common layer 223-2, and a part of the second charge generation layer 224-2. That is, a part of the 1-2 common layer 221-2, a part of the 2-2 common layer 223-2, and a part of the second charge generation layer 224-2 may be disposed on the heating metal layer HML. On a plane, a part of the heating metal layer HML may overlap a part of the 1-3 common layer 221-3, a part of the 2-3 common layer 223-3, and a part of the third charge generation layer 224-3. A part of the 1-3 common layer 221-3, a part of the 2-3 common layer 223-3, and a part of the third charge generation layer 224-3 may be disposed on the heating metal layer HML.

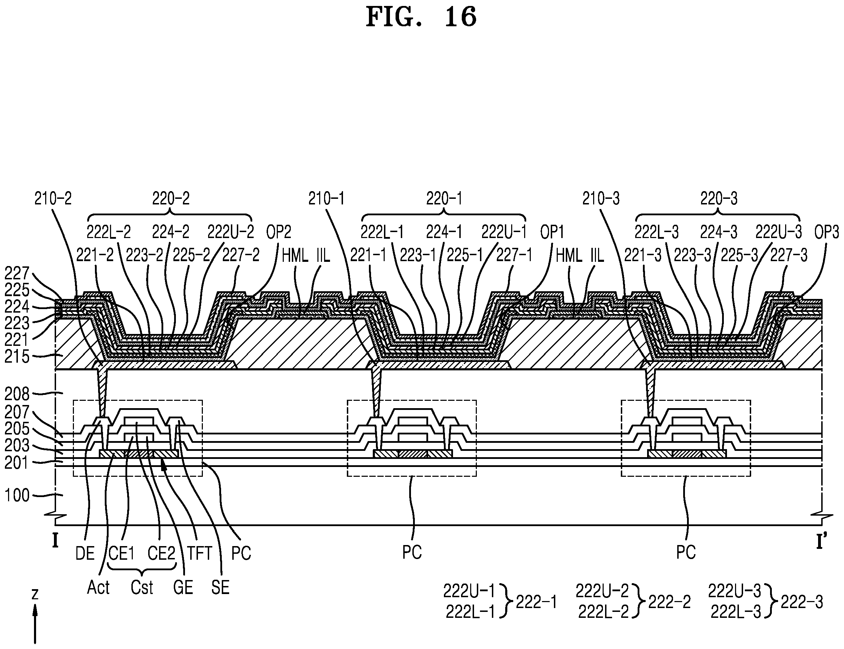

As illustrated in FIG. 16, the third common layer 225, the first upper emission layer 222U-1, the second upper emission layer 222U-2, the third upper emission layer 222U-3, and the fourth common layer 227 may be sequentially stacked on the first charge generation layer 224-1, the second charge generation layer 224-2, and the third charge generation layer 224-3.

More specifically, the third common layer 225 may be formed over the first charge generation layer 224-1, the second charge generation layer 224-2, and the third charge generation layer 224-3. The first upper emission layer 222U-1, the second upper emission layer 222U-2, and the third upper emission layer 222U-3 may be formed on the third common layer 225 such that the first upper emission layer 222U-1, the second upper emission layer 222U-2, and the third upper emission layer 222U-3 respectively overlap the first lower emission layer 222L-1, the second lower emission layer 222L-2, and the third lower emission layer 222L-3. The fourth common layer 227 may be formed over the first upper emission layer 222U-1, the second upper emission layer 222U-2, and the third upper emission layer 222U-3.

The third common layer 225 and the fourth common layer 227 may be commonly deposited to correspond to the entire surface of the display area DA by using an open mask. That is, unlike the method of manufacturing a display device described above in relation to FIGS. 7 to 13, in the method of manufacturing a display device according to the present embodiment, the third common layer 225 may be the unpatterned third preliminary common layer P225, and the fourth common layer 227 may be the unpatterned fourth preliminary common layer P227. Accordingly, the 3-1 common layer 225-1 may be in contact with the 3-2 common layer 225-2, and the 4-1 common layer 227-1 may be in contact with the 4-2 common layer 227-2. The 3-1 common layer 225-1 may be in contact with the 3-3 common layer 225-3, and the 4-1 common layer 227-1 may be in contact with the 4-3 common layer 227-3.

The first upper emission layer 222U-1, the second upper emission layer 222U-2, and the third upper emission layer 222U-3 may be formed through patterning per pixel. The first upper emission layer 222U-1, the second upper emission layer 222U-2, and the third upper emission layer 222U-3 may be formed by using an FMM, and/or an inkjet method, etc.

As the method of forming the third common layer 225 and the fourth common layer 227 and the material forming the same may be the same as those of the third preliminary common layer P225 and the fourth preliminary common layer P227 described above in relation to FIG. 11, and the method of forming the first upper emission layer 222U-1, the second upper emission layer 222U-2, and the third upper emission layer 222U-3 and the material forming the same may be the same as those of the first upper emission layer 222U-1, the second upper emission layer 222U-2, and the third upper emission layer 222U-3 described above in relation to FIG. 11, any redundant descriptions thereon are omitted.

In comparison with the method of manufacturing a display device described above in relation to FIGS. 7 to 13, in the method of manufacturing a display device according to the present embodiment, a voltage may be applied to the heating metal layer HML when only the first preliminary common layer P221, the first lower emission layer 222L-1, the second lower emission layer 222L-2, the third lower emission layer 222L-3, the second preliminary common layer P223, and the preliminary charge generation layer P224 are sequentially stacked on the first pixel electrode 210-1, the second pixel electrode 210-2, and the third pixel electrode 210-3. That is, in the method of manufacturing a display device according to the present embodiment, only a part of the first preliminary common layer P221, a part of the second preliminary common layer P223, and a part of the preliminary charge generation layer P224 each overlapping the heating metal layer HML may be removed. Accordingly, the sub-common layers disposed on the charge generation layer 224 may be in contact with each other. More specifically, the 3-1 common layer 225-1 may be in contact with the 3-2 common layer 225-2, and the 4-1 common layer 227-1 may be in contact with the 4-2 common layer 227-2. The 3-1 common layer 225-1 may be in contact with the 3-3 common layer 225-3, and the 4-1 common layer 227-1 may be in contact with the 4-3 common layer 227-3.

As described above, to substantially implement the effect of preventing a leakage current, disconnection between sub-charge generation layers may act as a major factor. Accordingly, in the method of manufacturing a display device according to the present embodiment, as the first charge generation layer 224-1 and the second charge generation layer 224-2 are arranged spaced (e.g., arranged apart) from each other, no leakage current may flow between the first organic light-emitting diode OLED1 and the second organic light-emitting diode OLED2. Also, as the first charge generation layer 224-1 and the third charge generation layer 224-3 are arranged spaced (e.g., arranged apart) from each other, no leakage current may flow between the first organic light-emitting diode OLED1 and the third organic light-emitting diode OLED3, either.

In addition, in the method of manufacturing a display device according to the present embodiment, the inorganic insulating layer IIL may cover the heating metal layer HML as in the method of manufacturing a display device described above in relation to FIGS. 7 to 13. Accordingly, even when the disconnected sub-common layers and the sub-charge generation layers overlap the heating metal layer HML, the heating metal layer HML may not be electrically connected to the disconnected sub-common layers and the sub-charge generation layers on the heating metal layer HML. Thus, as a part of the preliminary common layers and a part of the preliminary charge generation layer that are spaced from the heating metal layer HML do not need to be removed, a voltage applied to the heating metal layer HML and the temperature of the heating metal layer HML may decrease. This may reduce damages on components adjacent to the heating metal layer HML and possibility of occurrence of defects during the manufacturing process.

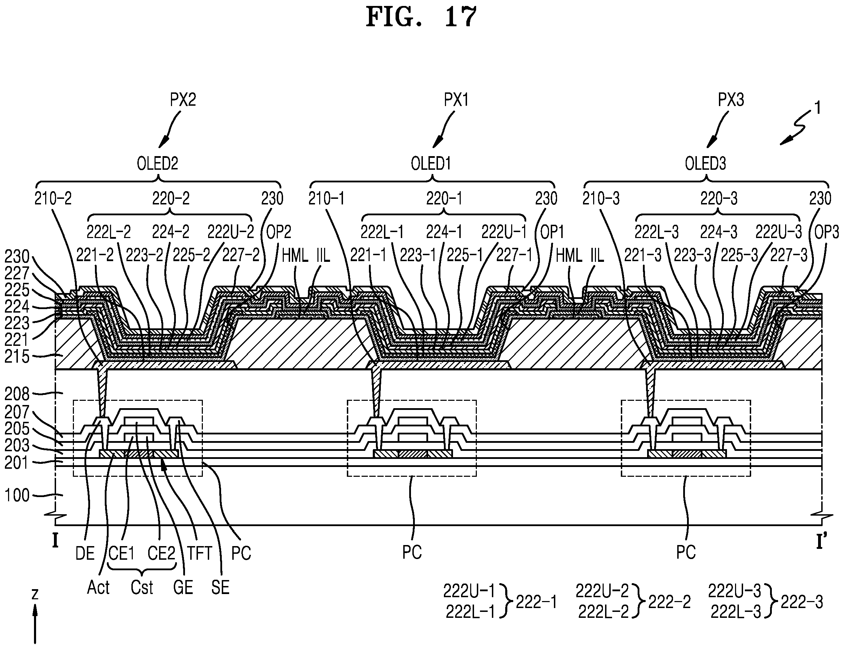

As illustrated in FIG. 17, the opposite electrode 230 may be formed over the upper surfaces of the first pixel electrode 210-1, the second pixel electrode 210-2, and the third pixel electrode 210-3. More specifically, the opposite electrode 230 may be formed in an integrated manner to correspond to the first pixel electrode 210-1, the second pixel electrode 210-2, and the third pixel electrode 210-3. Accordingly, the opposite electrode 230 may overlap all of the first pixel electrode 210-1, the second pixel electrode 210-2, and the third pixel electrode 210-3.

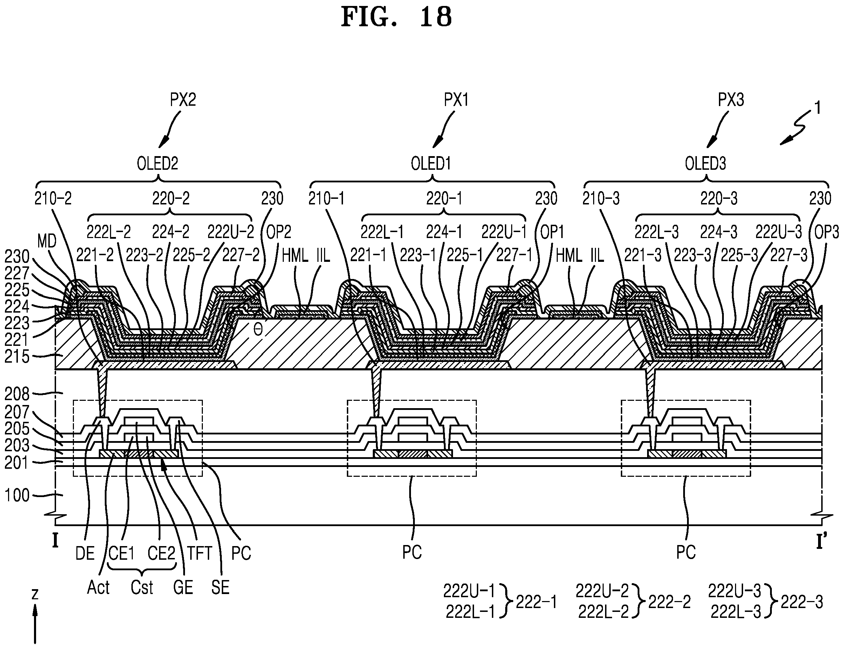

FIG. 18 is a cross-sectional view schematically illustrating the display device 1 according to one or more embodiments. As this is merely an embodiment of FIG. 4 with slight modifications, embodiments are described focusing on the differences.

As illustrated in FIG. 18, in the display device 1 according to the present embodiment, the heating metal layer HML may be disposed on the pixel-defining layer 215, and the inorganic insulating layer IIL may cover the heating metal layer HML. However, as for the display device 1 according to the present embodiment, as the joule heat is generated from the heating metal layer HML by applying a voltage to the heating metal layer HML for a long time during the manufacturing process of the display device 1, a part of the organic material on the heating metal layer HML may be removed sufficiently. Accordingly, on a plane, the charge generation layer 224, the first common layer 221, the second common layer 223, the third common layer 225, and the fourth common layer 227 may be arranged spaced (e.g., arranged apart) from the heating metal layer HML. That is, a part of the charge generation layer 224, a part of the first common layer 221, a part of the second common layer 223, a part of the third common layer 225, and a part of the fourth common layer 227 may not be disposed on the heating metal layer HML.

In this case, a mound MD including an organic material may be disposed on a part of the fourth common layer 227 adjacent to the heating metal layer HML. More specifically, there may be a plurality of mounds MD, and the plurality of mounds MD may be disposed on parts of the 4-1 common layer 227-1 adjacent to the heating metal layer HML, part of the 4-2 common layer 227-2 adjacent to the heating metal layer HML, or part of the 4-3 common layer 227-3 adjacent to the heating metal layer HML. The mound MD may include the same material as a material included in at least one of the charge generation layer 224, the first common layer 221, the second common layer 223, the third common layer 225, and the fourth common layer 227. That is, the mound MD may be formed from the removed organic material when removing a part of the organic material on the heating metal layer HML. A taper angle (θ) of the charge generation layer 224, the first common layer 221, the second common layer 223, the third common layer 225, and the fourth common layer 227 may be 80° or less.

According to one or more embodiments as described above, a display device, in which leakage current flowing between adjacent display elements is prevented, may be implemented. However, the scope of the present disclosure is not limited to the above mentioned effects.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from scope as defined by the following claims and their equivalents.

## Claims

1. A display device comprising:
a first pixel electrode and a second pixel electrode that are spaced from each other on a substrate;
a pixel-defining layer including a first opening exposing a central portion of the first pixel electrode and a second opening exposing a central portion of the second pixel electrode;
a first lower emission layer on the first pixel electrode;
a second lower emission layer on the second pixel electrode;
a first upper emission layer on the first lower emission layer;
a second upper emission layer on the second lower emission layer;
a first charge generation layer interposed between the first lower emission layer and the first upper emission layer;
a second charge generation layer interposed between the second lower emission layer and the second upper emission layer;
an opposite electrode on the first pixel electrode and the second pixel electrode;
a heating metal layer on the pixel-defining layer and arranged between the first opening and the second opening when seen from a direction perpendicular to the substrate; and
an inorganic insulating layer covering the heating metal layer.

2. The display device of claim 1, wherein the first charge generation layer and the second charge generation layer are spaced from each other,
wherein a part of the first charge generation layer overlaps a part of the heating metal layer, and
wherein a part of the second charge generation layer overlaps another part of the heating metal layer.

3. The display device of claim 1 or 2, wherein at least one of:
a part of the inorganic insulating layer is interposed between a part of the first charge generation layer and a part of the heating metal layer, and wherein another part of the inorganic insulating layer is interposed between a part of the second charge generation layer and another part of the heating metal layer;
the inorganic insulating layer covers an upper surface and a lateral surface of the heating metal layer; and
the inorganic insulating layer covers an upper surface of the pixel-defining layer.

4. The display device of claim 1, 2 or 3, wherein the heating metal layer surrounds each of the first opening and the second opening on a plane.

5. The display device of any preceding claim, further comprising:
a 1-1 common layer interposed between the first pixel electrode and the first lower emission layer;
a 1-2 common layer interposed between the second pixel electrode and the second lower emission layer;
a 2-1 common layer interposed between the first lower emission layer and the first charge generation layer; and
a 2-2 common layer interposed between the second lower emission layer and the second charge generation layer,
wherein the 1-1 common layer and the 1-2 common layer are spaced from each other,
wherein the 2-1 common layer and the 2-2 common layer are spaced from each other,
wherein a part of the 1-1 common layer and a part of the 2-1 common layer overlap a part of the heating metal layer, and
wherein a part of the 1-2 common layer and a part of the 2-2 common layer overlap another part of the heating metal layer.

6. The display device of claim 5, wherein a part of the inorganic insulating layer is interposed between a part of the 1-1 common layer and a part of the heating metal layer, and
wherein another part of the inorganic insulating layer is interposed between a part of the 1-2 common layer and another part of the heating metal layer.

7. The display device of claim 6, further comprising:
a 3-1 common layer interposed between the first charge generation layer and the first upper emission layer;
a 3-2 common layer interposed between the second charge generation layer and the second upper emission layer;
a 4-1 common layer interposed between the first upper emission layer and the opposite electrode; and
a 4-2 common layer interposed between the second upper emission layer and the opposite electrode.

8. The display device of claim 7, wherein at least one of:
the 3-1 common layer and the 3-2 common layer are spaced from each other, and wherein the 4-1 common layer and the 4-2 common layer are spaced from each other; and
the 3-1 common layer is in contact with the 3-2 common layer, and
wherein the 4-1 common layer is in contact with the 4-2 common layer.

9. A method of manufacturing a display device, the method comprising:
forming a first pixel electrode and a second pixel electrode that are spaced from each other on a substrate;
forming, on the substrate, a pixel-defining layer including a first opening exposing a central portion of the first pixel electrode and a second opening exposing a central portion of the second pixel electrode;
forming, on the pixel-defining layer, a heating metal layer between the first opening and the second opening when seen from a direction perpendicular to the substrate;
forming, on the pixel-defining layer, an inorganic insulating layer covering the heating metal layer;
forming a first preliminary common layer over the first pixel electrode and the second pixel electrode;
forming, on the first preliminary common layer, a first lower emission layer and a second lower emission layer overlapping the first pixel electrode and the second pixel electrode, respectively;
forming a second preliminary common layer over the first lower emission layer and the second lower emission layer;
forming a preliminary charge generation layer on the second preliminary common layer;
forming a third preliminary common layer on the preliminary charge generation layer;
forming, on the third preliminary common layer, a first upper emission layer and a second upper emission layer overlapping the first lower emission layer and the second lower emission layer, respectively;
forming a fourth preliminary common layer over the first upper emission layer and the second upper emission layer;
removing a part of the first preliminary common layer, a part of the second preliminary common layer, a part of the preliminary charge generation layer, a part of the third preliminary common layer, and a part of the fourth preliminary common layer, each overlapping the heating metal layer, by applying a voltage to the heating metal layer; and
forming an opposite electrode over the first pixel electrode and the second pixel electrode.

10. A method of manufacturing a display device, the method comprising:
forming a first pixel electrode and a second pixel electrode that are spaced from each other on a substrate;
forming, on the substrate, a pixel-defining layer including a first opening exposing a central portion of the first pixel electrode and a second opening exposing a central portion of the second pixel electrode;
forming, on the pixel-defining layer, a heating metal layer arranged between the first opening and the second opening when seen from a direction perpendicular to the substrate;
forming, on the pixel-defining layer, an inorganic insulating layer covering the heating metal layer;
forming a first preliminary common layer over the first pixel electrode and the second pixel electrode;
forming, on the first preliminary common layer, a first lower emission layer and a second lower emission layer overlapping the first pixel electrode and the second pixel electrode, respectively;
forming a second preliminary common layer over the first lower emission layer and the second lower emission layer;
forming a preliminary charge generation layer on the second preliminary common layer;
removing a part of the first preliminary common layer, a part of the second preliminary common layer, and a part of the preliminary charge generation layer, each overlapping the heating metal layer, by applying a voltage to the heating metal layer;
forming a third common layer over a first charge generation layer and a second charge generation layer each formed by removing a part of the preliminary charge generation layer;
forming, on the third common layer, a first upper emission layer and a second upper emission layer overlapping the first lower emission layer and the second lower emission layer, respectively;
forming a fourth common layer over the first upper emission layer and the second upper emission layer; and
forming an opposite electrode over the first pixel electrode and the second pixel electrode.

11. The method of claim 9 or 10, wherein the forming of the inorganic insulating layer comprises forming the inorganic insulating layer to cover an upper surface and a lateral surface of the heating metal layer.

12. The method of claim 9, 10 or 11, wherein the forming of the heating metal layer comprises forming the heating metal layer to be around each of the first opening and the second opening on a plane.

13. The method of claim 9, or claim 11 or 12 when dependent on claim 9, wherein the removing of the part of the first preliminary common layer, the part of the second preliminary common layer, the part of the preliminary charge generation layer, the part of the third preliminary common layer, and the part of the fourth preliminary common layer comprises removing a part of the first preliminary common layer, a part of the second preliminary common layer, a part of the preliminary charge generation layer, a part of the third preliminary common layer, and a part of the fourth preliminary common layer, each overlapping a central portion of the heating metal layer.

14. The method of claim 10, or claim 11 or 12 when dependent on claim 10, wherein the removing of the part of the first preliminary common layer, the part of the second preliminary common layer, and the part of the preliminary charge generation layer comprises removing a part of the first preliminary common layer, a part of the second preliminary common layer, and a part of the preliminary charge generation layer, each overlapping a central portion of the heating metal layer.

15. An electronic device comprising:
a display device; and
a housing accommodating the display device and forming an exterior,
wherein the display device comprises:
a first pixel electrode and a second pixel electrode that are spaced from each other on a substrate;
a pixel-defining layer including a first opening exposing a central portion of the first pixel electrode and a second opening exposing a central portion of the second pixel electrode;
a first lower emission layer on the first pixel electrode;
a second lower emission layer on the second pixel electrode;
a first upper emission layer on the first lower emission layer;
a second upper emission layer on the second lower emission layer;
a first charge generation layer interposed between the first lower emission layer and the first upper emission layer;
a second charge generation layer interposed between the second lower emission layer and the second upper emission layer;
a heating metal layer on the pixel-defining layer and arranged between the first opening and the second opening when seen from a direction perpendicular to the substrate; and
an inorganic insulating layer covering the heating metal layer.
